# EUROPEAN PATENT APPLICATION

(11) **EP 1 798 855 A2**
(43) Date of publication of application: **20.06.2007**
(21) Application number: 06125814.1
(22) Date of filing: 11.12.2006
(51) Int. Cl.: H03F 3/217, H03F 1/32

(54) **Class D Amplifier**

(30) Priority: 13.12.2005 JP 2005359328
(71) Applicant: MATSUSHITA ELECTRIC INDUSTRIAL CO., LTD., Kadoma-shi, Osaka 571-8501 (JP)
(72) Inventor: Mochizuki, Kouji, Matsushita El. Ind. Co., Ltd., Chuo-ku, Osaka-shi Osaka 540-6319 (JP)
(74) Representative: Grünecker, Kinkeldey, Stockmair & Schwanhäusser Anwaltssozietät

(57) **Abstract**

A class D amplifier is provided that is capable of reducing distortion of a specific sampling frequency, and frequencies that are multiples of this frequency to a level where an LPF is not required and small-scale control circuit. Class D amplifier (100) is provided with H (full) bridge output section (120), output control section (110) that is configured with random number generator (103) that takes individual random numbers that do not depend on input values as output values, and PWM control signal generating circuit (104) that generates a final PWM control signal from the input values and output values of random number generator (103). Output control section (110) divides a pulse signal outputted at a reference point between sampling frequencies into a plurality of pulse signals with random widths that do not include the reference point , and outputs the pulse signals with random widths.

## Description

### BACKGROUND OF THE INVENTION

### 1. Field of the Invention

The present invention relates to a class D amplifier that operates using switching techniques, and more particular, to a class D amplifier suitable for use in audios that carry out power amplification of a PWM (Pulse Width Modulation) signal using switching operation corresponding to the PWM signal based on a speech signal etc. and supply the obtained output signal to a load including a speaker etc.

### 2. Description of the Related Art

In a sound apparatus that amplifies a speech, supplies the signal to a speaker, and obtains speech corresponding to the speech signal from the speaker, various methods are adopted for amplification of the speech signal according to various purposes. In particular, there are improved methods for the case of obtaining an output signal for exciting the speaker based on the input speech signal. Regarding power amplification for speech signals, a class D amplifier that carries out so-called class D operation is used in active amplifying elements such as transistors.

The class D amplifier achieves extremely good power conversion efficiency compared to an analog linear amplifier such as a class AB amplifier, and the amount of heat discharge is also small, so that the class D amplifier is often adopted as an amplifier for exciting a speaker. In the class D amplifier, active amplifying elements such as transistors to be used carry out, for example, switching operation according to the input signal that is a speech signal. Then, for example, as a power amplification circuit that carries out amplification for the speech signal using the class D amplifier, the power amplification circuit has been proposed that obtains a PWM signal based on the input speech signal, carries out power amplification for the PWM signal, and supplies the PWM signal subjected to power amplification to a speaker section.

Typically, the PWM signal is outputted as a pulse signal at a predetermined period referred to as a sampling frequency. This sampling frequency is extremely high compared to an upper limit of 20 kHz for normal speech frequencies, and therefore the output signal of the class D amplifier includes distortion of this sampling frequency, a frequency of half of this frequency, and frequencies that are multiples of this frequency.

This high-frequency distortion rapidly deteriorates the coil that is the most fundamental and main component of the speaker section. Although the PWM signal is connected to the speaker section using a LPF (low pass filter) inserted between them in the related art, in recent years, several class D amplifiers that do not require the LPF, which is required in the related art, have been proposed. The LPF is inserted in order to prevent damage to a speaker circuit etc. that is a load and comply with specified EMI specifications.

For example, the prior-art class D amplifier which does not require the LPF, carries out end-to-end modulation of two PWM signals of positive phase and inverted phase depending on the input signal and reduces distortion of the specific sampling frequency, a frequency of half of this frequency and frequencies that are multiples of this frequency by using the difference between these signals (for example, refer to Patent Document 1: US Patent No.6211728).

The distortion of the specific sampling frequency, the frequency of half of this frequency and frequencies that are multiples of this frequency, which determines the need of the LPF, is caused by the fact that it is necessary to generate a pulse signal having a specific periodicity so that a reference point of time intervals determined in advance by this sampling frequency becomes the same as, for example, a center point of the pulse width of the PWM signal or one of the edges of the pulse signal.

With the class D amplifier disclosed in Patent Document 1, when the input value is zero, two PWM signals of positive phase and inverted phase output a clock waveform where a high potential segment and low potential segment are the same. The class D amplifier performs control to operate so that the edges of both ends of the PWM signal of positive phase move linearly apart in accordance with an increase of the input value, and the edges of both ends of the PWM signal of inverted phase linearly approach according to the input value.

Differential signals obtained as a result of this control are two pulse signals per predetermined time interval and change so that the pulse signals move apart or approach each other according to the input value or the pulse signals themselves broaden and narrow.

Further, the differential signals obtained as a result of this control are not the conventional PWM signals of two values, but PWM signals of three values. Therefore, the signal amplitude per one pulse of the differential pulse signal obtained as a result of this control is half of the signal amplitude per one pulse of the conventional PWM signal of two values, so that the high-frequency signal and high-frequency noise generated at the frequency domain relating to the EMI specifications can be reduced to half or less.

By using these methods, with the class D amplifier disclosed in Patent Document 1, the distortion of the specific sampling frequency, the frequency of half of this frequency, and frequencies that are multiples of this frequency is reduced to a level where the LPF is not required.

Further, as the conventional class D amplifier, by changing the sampling frequency in a random manner, there is a class D amplifier that reduces the distortion of the specific sampling frequency, the frequency of half of this frequency, and frequencies that are multiples of this frequency (for example, refer to Patent Document 2: US Patent No.6847257).

If the sampling frequency changes in a random manner, the reference point of the time interval determined in advance by this sampling frequency also changes in a random manner. With the class D amplifier disclosed in Patent Document 1, the output signals are observed as always fluctuating without the predetermined time intervals. By using these methods, with the class D amplifier disclosed in Patent Document 2, the distortion of the specific sampling frequency, the frequency of half of this frequency, and frequencies that are multiples of this frequency is reduced to a level where the LPF is not required.

However, this kind of conventional class D amplifier has the following problems.

With the class D amplifier disclosed in Patent Document 1, when the input value is a fixed value or a signal that changes slightly, the PWM signal of positive phase and the PWM signal of invertedphase do not fluctuate substantially, and therefore the differential signals obtained as a result of this control become two pulse signals where the periodicity and pulse width are substantially fixed per predetermined time interval. As a result, the distortion of the specific sampling frequency, the frequency of half of this frequency, and frequencies that are multiples of this frequency, which does not occur when the input value fluctuates, increases.

Even when the input value is a fixed value or a signal that changes slightly, as a class D amplifier in which there is no increase in the above-described distortion, there is the class D amplifier disclosed in Patent Document 2.

However, in order to implement the circuit disclosed in Patent Document 2, it is necessary to provide a re-sampling circuit for the input signal for responding to the sampling frequency that always changes in a random manner, or a complex, large-scale circuit for recalculating the pulse width of the PWM signal that changes according to the fluctuation of the sampling frequency and that should be outputted.

Further, in some cases, calculation errors due to re-sampling or fluctuation of the sampling frequency causes new noise and distortion in the class D amplifier itself, and, an analogue circuit including an operational amplifier, capacitor and resistor is required for generating a triangular wave which is a reference signal for generating a PWM signal. Therefore, characteristic deterioration and increase in circuit scale cannot be avoided.

### SUMMARY OF THE INVENTION

It is therefore an object of the present invention to provide a class D amplifier that can reduce the distortion of a specific sampling frequency, the frequency of half of this frequency, and frequencies that are multiples of this frequency to a level where an LPF is not required even when an input value is a fixed value or a signal that slightly changes, and that can be implemented with a simple and small-scale control circuit.

According to an aspect of the invention, a class D amplifier having: an output section that takes a potential difference between a first output terminal and a second output terminal as a differential signal output; and an output control section that supplies a PWM control signal for changing the state of the potential difference between the first output terminal and the second output terminal, wherein the output control section comprises a pulse signal generating section that divides a pulse signal outputted at a reference point between sampling frequencies into a plurality of pulse signals with random widths that do not include the reference point, and outputs the pulse signals with random widths.

### BRIEF DESCRIPTION OF THE DRAWINGS

The above and other objects and features of the invention will appear more fully hereinafter from a consideration of the following description taken in connection with the accompanying drawing wherein one example is illustrated by way of example, in which;
FIG.1 shows an output signal waveform to explain the fundamental concept of the present invention;
FIG.2 illustrates a method of generating a pulse signal with a random pulse width of the present invention;
FIG.3 is a circuit diagram showing a configuration of a class D amplifier according to Embodiment 1 of the present invention;
FIG.4 is a block diagram showing a detailed configuration of a PWM control signal generating circuit of the class D amplifier according to Embodiment 1;
FIG.5 shows an example of a linear PWM signal with respect to the input signal of the class D amplifier according to Embodiment 1;
FIG.6 is a signal waveform diagram generated by the class D amplifier according to Embodiment 1;
FIG.7 is a circuit diagram showing a configuration of the class D amplifier according to Embodiment 2 of the present invention;
FIG.8 is a block diagram showing a detailed configuration of the PWM control signal generating circuit of the class D amplifier according to Embodiment 2;
FIG. 9 shows an address/output value of a ROM of FIG. 8 and an output waveform generated by the address/output value;
FIG.10 is a signal waveform diagram generated by the class D amplifier according to Embodiment 2;
FIG. 11 is a circuit diagram showing a configuration of the class D amplifier according to Embodiment 3 of the present invention;
FIG.12 is a circuit diagram showing a configuration of the class D amplifier according to Embodiment 4 of the present invention;
FIG.13 is a circuit diagram showing a configuration of the class D amplifier according to Embodiment 5 of the present invention;
FIG.14 is a circuit diagram showing a configuration of the class D amplifier according to Embodiment 6 of the present invention; and
FIG.15 shows an address/output value of a ROM of FIG.8 and an output waveform generated by the address/output value.

### DESCRIPTION OF THE PREFERRED EMBODIMENTS

Embodiments of the present invention will be described in detail below with reference to the accompanied drawings.

### (Description of Theory)

First, the fundamental concept of the present invention will be described.

The technology disclosed in Patent Document 2 is capable of reducing the distortion of the specific sampling frequency, the frequency of half of this frequency, and frequencies that are multiples of this frequency to a level where the LPF is not required by shifting the sampling frequency itself. However, in order to implement the circuit disclosed in Patent Document 2, it is necessary to provide a re-sampling circuit for the input signal for responding to the sampling frequency that always changes in a random manner, or a complex, large-scale circuit for recalculating the pulse width of the PWM signal that changes according to the fluctuation of the sampling frequency and that should be outputted.

The present invention focuses on the fact that a reference point for an output signal waveform exists between sampling frequencies fs, and divides the pulse signal into at least two before and after the reference point at the reference point between sampling frequencies fs so that the pulse signal of the output signal waveform is not outputted as is. This dividing is performed in a random manner (where the dividing position, the number of dividings, appearing pattern, and frequency of occurrence are random), and the positions of the pulse signals divided between sampling frequencies fs are arbitrary. Sampling frequencies fs remain fixed. However, a plurality of pulse signals with random widths divided in a random manner are outputted at random positions, while avoiding the reference point between sampling frequencies fs, so that the period of the pulse signal at the reference point is spread in the time axis direction, and the distortion of the specific sampling frequency, a frequency of half of this frequency and frequencies that are multiples of this frequency is reduced to a level where the LPF is not required. The method of dividing the pulse signal may simply divide the pulse signal into a plural at a predetermined fixed dividing ratio. However, in order to increase the accuracy by improving the efficiency and reducing errors, the pulse signal is divided in a random manner using the method described in the following. Further, it is also possible to modify the above-described dividing method in a random manner or adaptively.

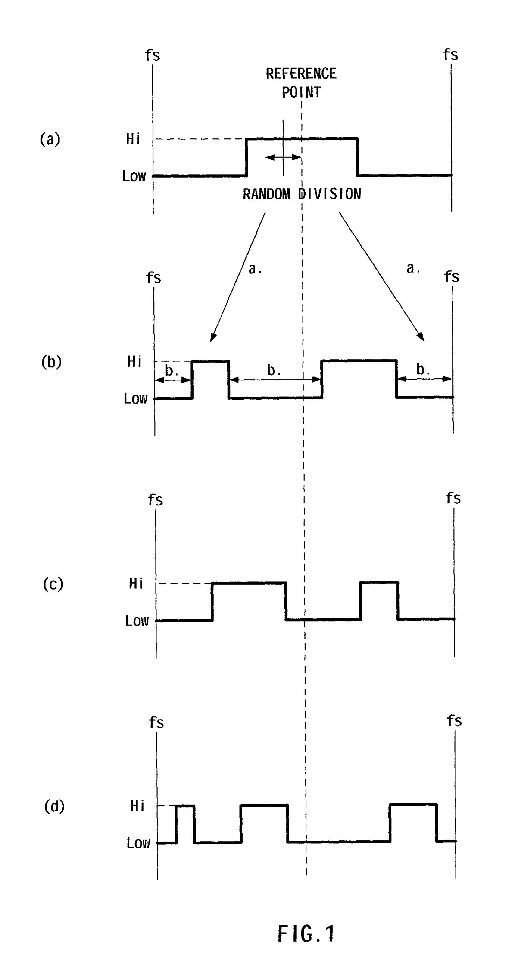

FIG. 1 shows the output signal waveform to explain the above-described fundamental concept. In FIG.1, sampling frequency fs is fixed. Further, a dashed line of FIG.1 shows a reference point of sampling frequency fs. FIG. 1 (a) is an output signal wave form before dividing, and this output signal waveform is divided in a random manner for each predetermined time (refer to a.). FIG.1(b) is an example of the PWM signal of the output signal waveform after divided in a random manner, and, when the divided pulse signals are combined, the pulse width is the same as the original pulse width (ignoring a compensated part). Similarly, FIG.1(c) is an example of another PWM signal after divided in a random manner. As shown in FIGs.1(b) and (c), the output signal waveform is divided in a random manner, so that, the PWM signal at a given period after divided is a combination of the pulse signals with random widths. In addition to this, positions of the PWM signal after divided are shifted in a random manner, while avoiding the reference point in the fixed sampling frequency fs (refer to b.). The above is an example of dividing the pulse signal into two, but, as shown in FIG.1 (d), dividing the pulse signal into three (or more) in a random manner is also possible, and the pulse width of a combination of the divided pulse signals is equal to the original pulse width. Positions of the PWM signal after divided into three are shifted in a random manner, while avoiding the reference point in the fixed sampling frequency fs. Further, it is also possible to appropriately switch between dividing the signal into two and dividing the signal into three at a predetermined timing.

When the PWM signal appearing at the output terminal is viewed at a given time unit, the pulse signal at the reference point is spread in the time axis direction, in other words, the differential output signal is linear with respect to the input, but the pulse period is irregular due to the added random pulse width, so that the distortion of the specific sampling frequency, the frequency of half of this frequency, and frequencies that are multiples of this frequency is reduced to a level where the LPF is not required. In the prior-art example, since the sampling frequency itself is shifted periodically, a complex, large-scale circuit is required for recalculating the pulse width of the PWM signal that changes according to the fluctuation of the sampling frequency and that should be outputted. However, the sampling frequency fs of the class D amplifier according to the present invention is fixed, so that implementation with only a simple and small-scale control circuit is possible.

Next, the generation of a pulse signal with a random width will be described.

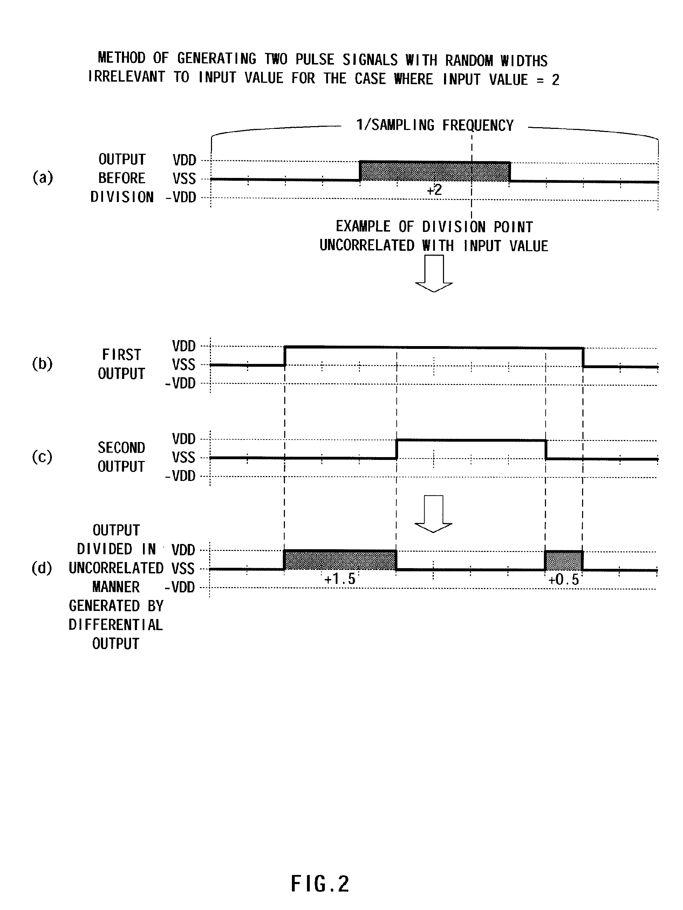

FIG.2 illustrates a method of generating a pulse signal with a random width. A method of generating two pulse signals with random widths irrelevant to the input value for the case where the input value = 2, will be described.

As shown in FIG.2(a), as the pulse signal output before divided, one pulse signal per sampling frequency is outputted.
At a typical PWM control signal generating circuit, this pulse signal is used as an output.

The class D amplifier according to the present invention carries out control so that the pulse signal outputted for each sampling frequency becomes a combination of two or more pulse signals with random widths. As an example of the specific method, a configuration is adopted having an output section for outputting a differential PWM signal, a random number generator for outputting a random value irrelevant to the input value, and a PWM control signal generating circuit for outputting a PWM control signal for controlling an output section from the random value and the input value.

Any kind of pulse signal generation method is possible providing that the method generates two or more pulse signals shifted in a random manner, while avoiding the reference point within the fixed sampling frequency. In the following, using the output value of the random number generator as an index, an example of dividing the pulse signal outputted for each sampling frequency in an uncorrelated manner and generating two pulse signals with random widths irrelevant to the input value, will be described. Further, in the case of generating two pulse signals with random widths irrelevant to the input value, it is further preferable to use a differential signal output for the reasons described below.

The pulse signal can be implemented using either the single output or the differential signal output, but use of the differential signal output has a high superiority to ensure characteristics, and therefore a description will be given assuming the case of using the differential signal output.

A first output shown in FIG.2 (b) is a pulse signal of positive phase, and a second output shown in FIG.2 (c) is a pulse signal of inverted phase. FIG.2(d) is an output generated using the above-described two differential pulse signals and divided in an uncorrelated manner. The random generator generates the above-described pulse signal of positive phase and pulse signal of inverted phase shown in FIGs.2(b) and (c), and by applying the signals to the load at the same time, a potential difference between both ends in the load becomes equal to the state where the PWM signal shown in FIG.2(d) is applied. It is also possible to generate the PWM signal shown in FIG.2(d) in advance using the PWM control signal generating circuit configured with a flip-flop and logical circuit etc. and apply the signal to the load. The above-described description is for the case of the differential signal output, but in the case of a single output, a method of generating a PWM signal shown in FIG.2(d) in advance using the PWM control signal generating circuit configured with a flip-flop and logical circuit etc. and applying the signal to the load, is used.

The PWM signal generated in this way is two differential pulse signals with random widths irrelevant to the input value, made up of a potential difference between a PWM signal of positive phase and a PWM signal of inverted phase. This differential pulse signal is two pulse signals per time interval determined in advance by the sampling frequency, but the total value of the pulse widths of the two pulse signals before divided maintain the one-to one relation with the input values. In FIG.2, the input value (=2) indicated with the shading in FIG.2 (a) and the output of the total value (1.5 + 0.5) of the two pulse widths indicated with the shading in FIG.2(d) are equal. By this means, linear input/output characteristics are compensated between the input value and the differential output value of the class D amplifier.

When the dividing point is not random, a high-frequency component is generated having peaks at a specific frequency corresponding to this dividing point and frequencies that are multiples of this frequency, and power of the high frequency domain is concentrated and increases at the specific frequencies, so that, if the LPF is not added, the speaker circuit that is a load may be damaged, or VCCI, or the EMI specifications specified in FCC part 15 may not be complied with.

Namely, by making the dividing point random, a high-frequency component depending on the sampling frequency and the dividing point is dispersed evenly over the high-frequency domain, and, as a result, it is possible to avoid concentration of power at the specific frequencies and comply with the above-described EMI specifications without adding the LPF, and use as filter-less is possible.

Further, the random number generator required to generate the PWM signal of positive phase and the PWM signal of inverted phase can be implemented using an extremely small number of flip-flops and XOR circuits as with a modulo pseudo-random generator. It is possible to implement the PWM control signal generating circuit simply with a small scale with a circuit using a combination of a comparatively small number of flip-flops, selectors, adders, counters, inverters and basic logic elements such as AND and OR elements, or with a circuit using a ROM.

### (Embodiment 1)

FIG.1 is a circuit diagram showing a configuration of the class D amplifier according to Embodiment 1 of the present invention based on the above-described basic concepts. This embodiment is an example of application to a class D amplifier suitable for use in an audio that outputs a PWM signal to be supplied to an inductive load such as a speaker.

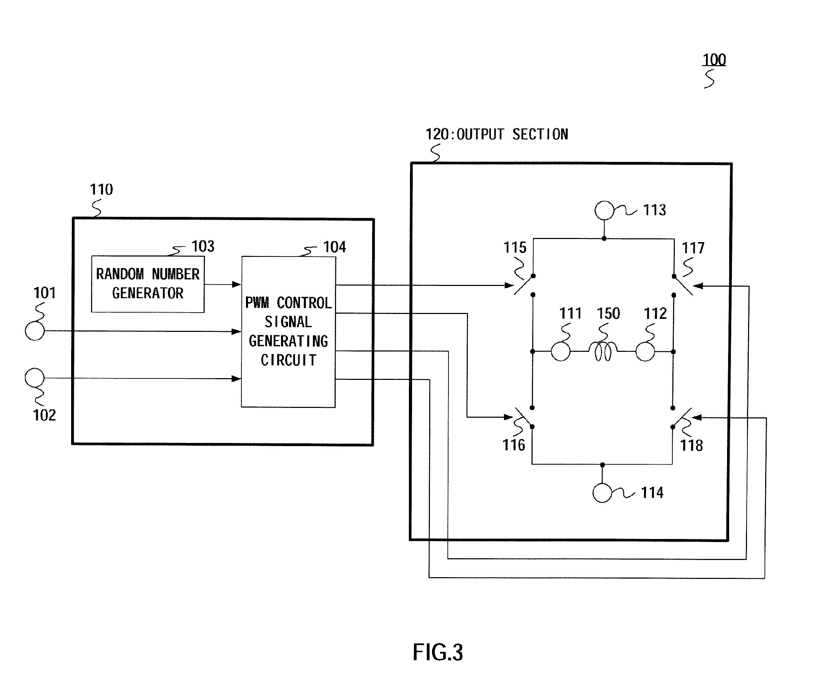

In FIG. 3, class D amplifier 100 is configuredhaving: output control section 110 that is configured with input terminal 101, mute signal input terminal 102, random number generator 103 and PWM control signal generating circuit 104; and output section 120 that is configured with first and second output terminals 111 and 112 to which inductive load 150 such as a speaker is connected, first power supply terminal 113 that supplies a first potential, second power supply terminal 114 that supplies a second potential, first switch 115 that connects first power supply terminal 113 and first output terminal 111, second switch 116 that connects first output terminal 111 and second power supply terminal 114, third switch 117 that connects first power supply terminal 113 and second output terminal 112, and fourth switch 118 that connects second output terminal 112 and second power supply terminal 114.

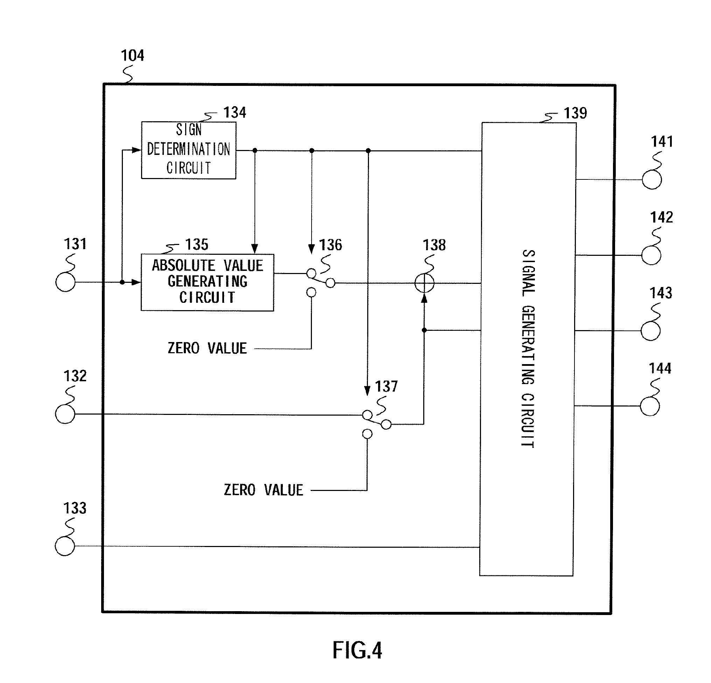

Output control section 110 supplies a plurality of control signals for changing the state of first output terminal 111 and second output terminal 112, and is provided with random number generator 103 that takes individual random numbers that do not depend on the input value as output values, and PWM control signal generating circuit 104 that generates a final PWM control signal from the input value and output values of random number generator 103. Random number generator 103 is configured with a modulo pseudo-random generator that is configured with a small number of flip-flops and XOR circuits. Further, the configuration of PWM control signal generating circuit 104 will be described later using FIG.4.

Output section 120 typically has a circuit configuration referredto as anH (full) bridge. Themost well-known function that is an advantage of an output section of the H (full) bridge is that it is possible to suppress characteristic power supply noise referred to as regenerative current even when inductive load 150 is connected between first output terminal 111 and second output terminal 112.

Output section 120 has first output terminal 111 and second output terminal 112. First output terminal 111 and second output terminal 112 output PWM waveforms where the potential of a Hi segment becomes the first potential, and the potential of a Lo segment becomes the second potential, and output a potential difference between first output terminal 111 and second output terminal 112 as a final differential signal output. To be more specific, by supplying a plurality of control signals generated using the input value to output control section 110, output section 120 has five output states of a first output state where first output terminal 111 and second output terminal 112 are both the first potential, a second output state where the potential of first output terminal 111 and second output terminal 112 are both the second potential, a third output state where the potential of first output terminal 111 is the first potential and the potential of second output terminal 112 is the second potential, a fourth output state where the potential of first output terminal 111 is the second potential and the potential of second output terminal 112 is the first potential, and a fifth output state where first output terminal 111 and second output terminal 112 are both in a high-impedance state.

In order to possess the five output states, output section 120 is provided with first, second, third and fourth switches 115 to 118. First and second switches 115 and 116 are connected in series between the first potential and the second potential. First output terminal 111 is provided at a connection point of first and second switches 115 and 116. Third and fourth switches 117 and 118 are connected in series between the first potential and the second potential, and second output terminal 112 is provided at a connection point of third and fourth switches 117 and 118. First, second, third and fourth switches 115 to 118 are configured, for example, with a MOS transistor. The details will be described later from Embodiment 2.

FIG.4 is a block diagram showing a detailed configuration of PWM control signal generating circuit 104.

In FIG.4, PWM control signal generating circuit is configured having: first input terminal 131 that receives an input value; second input terminal 132 that receives an output of random number generator 103; mute signal input terminal 133; sign determination circuit 134 that determines a sign and zero of the input value; absolute value generating circuit 135 that extracts an absolute value of the input signal; first selection circuit 136 that selects and outputs one of the output value and zero value of absolute value generating circuit 135 based on the output result of sign determination circuit 134; second selection circuit 137 that selects and outputs one of the output value and zero value of random number generator 103 based on the output result of sign determination circuit 134; adding circuit 138 that adds the output value of random number generator 103 and the output value of first selection circuit 136; signal generating circuit 139 that generates a final PWM control signal based the output result of sign determination circuit 134, the output value of adding circuit 138 and the output value of random number generator 103, and sets first output terminal 111 and second output terminal 112 to high-impedance based on the mute signal; and output terminals 141 to 144 that output the generated PWM control signal to first to fourth switches 115 to 118. First input terminal 131 that receives the input value is connected as is to input terminal 101 of PWM control signal generating circuit 104, and mute signal input terminal 133 is connected as is to mute signal input terminal 102 of PWM control signal generating circuit 104.

The operation of class D amplifier 100 with the above-described configuration will be described.

In class D amplifier 100, for example, a speech signal is supplied to PWM control signal generating circuit 104 of output control section 110 via input terminal 101 as an input signal. Individual random numbers are then supplied to PWM control signal generating circuit 104 from random number generator 103.

PWM control signal generating circuit 104 has four one-bit signal lines, and is capable of individually turning on and off first switch 115, second switch 116, third switch 117 and fourth switch 118 configuring output section 120. These switches are connected between the first potential supplied to first power supply terminal 113 and the second potential supplied to second power supply terminal 114.

When first potential VDD is supplied to first power supply terminal 113 and second potential VSS is supplied to second power supply terminal 114, as output states of first output terminal 111 and second output terminal 112 of output section 120, second PWM control signal generating circuit 104 is capable of maintaining the first state where first output terminal 111 and second output terminal 112 are both at VDD, a second state where first output terminal 111 and second output terminal 112 are both at VSS, a third state where first output terminal 111 is at VDD and second output terminal 112 is at VSS, and a fourth state where first output terminal 111 is at VSS and second output terminal 112 is at VDD. When a mute signal is inputted to mute signal input terminal 102, PWM control signal generating circuit 104 maintains a fifth state where first output terminal 111 and second output terminal 112 are both high-impedance by carrying out control so that all switches 115 to 118 are turned off.

At class D amplifier 100, it is possible to freely set a predetermined time interval--a sampling frequency--in accordance with target specifications of a product. However, undesirable frequency increases invite increases in current consumption. Therefore, in this embodiment, a sampling frequency is, for example, 200 kHz, a clock frequency for PWM indicating the resolution of the PWM signal is set at 2 MHz that is ten times of the sampling frequency, and a pulse shape of the PWM signal is set so as to be always included in the Hi pulse segment of the pulse signal using a center point of the predetermined time interval as a signal reference point. The following will be described based on the above-described setting conditions.

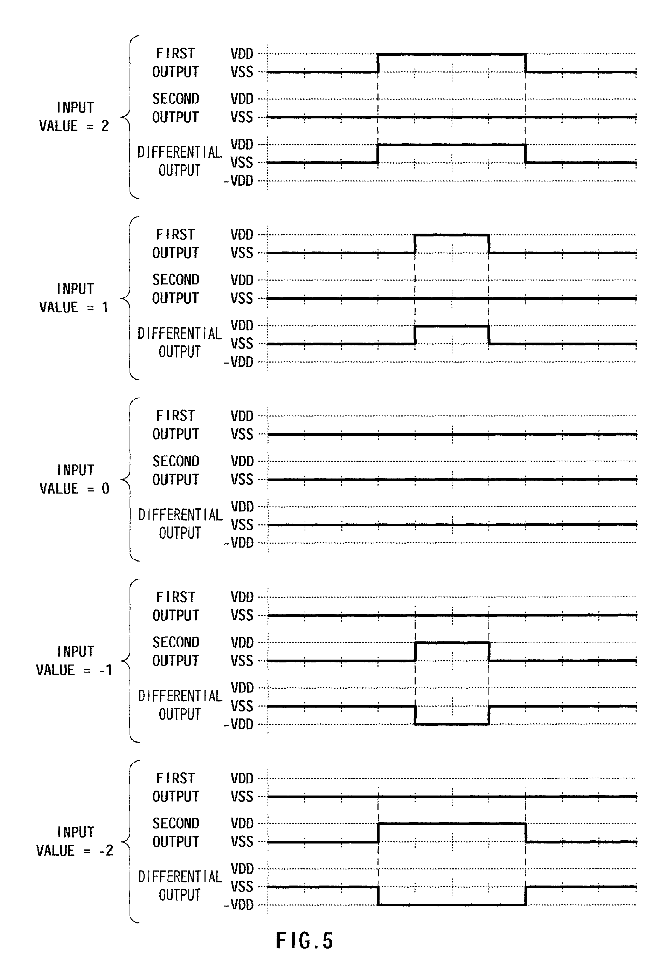

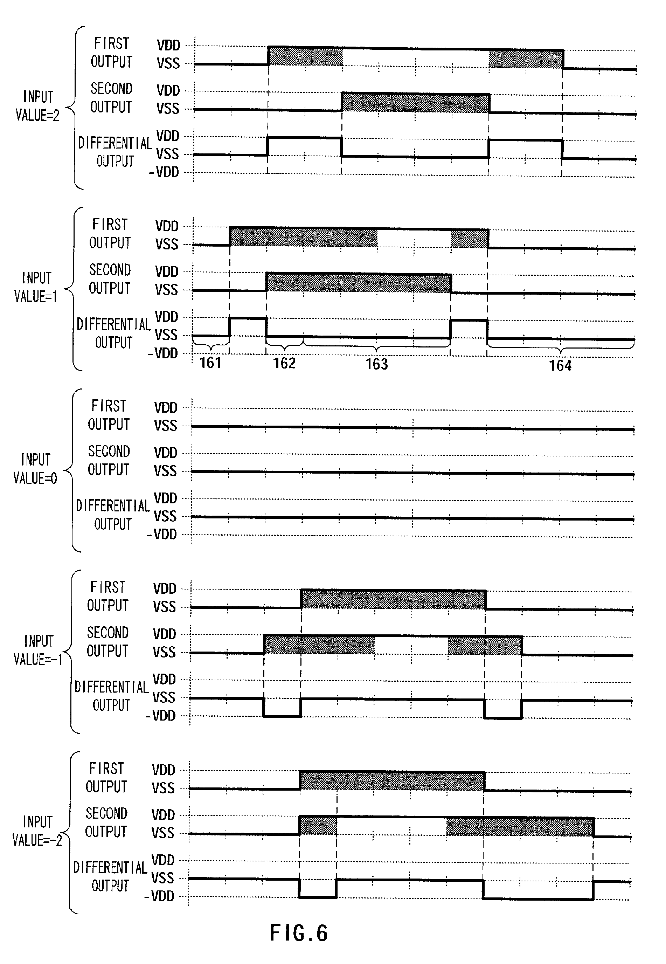

FIG.5 shows an example of a linear PWM signal with respect to the input signal, to explain a comparison with the signal waveform diagram of FIG.6.

FIG.5 is an example of a PWM signal linear with respect to the input signal for the case of the predetermined time interval, that is, at a sampling frequency of 200 kHz and a clock frequency for PWM of 2 MHz. When there is no output of random number generator 103, this is a PWM waveform of first output terminal 111 and second output terminal 112 and a differential output waveform of first output terminal 111 and second output terminal 112 for the case where the input signal supplied to PWM control signal generating circuit 104 via input terminal 101 changes from -2 to 2.

In the PWM waveforms shown in FIG. 5, the pulse width of first output terminal 111, second output terminal 112 and differential output waveform are all linear with respect to the input signal.

FIG. 6 is a signal waveform diagram generated by class D amplifier 100, and an example of a PWM waveform of first output terminal 111 and second output terminal 112, and a differential output waveform of first output terminal 111 and second output terminal 112, for the case where the input signal supplied to PWM control signal generating circuit 104 via input terminal 101 of class D amplifier 100 changes from -2 to 2.

As shown from the comparison with eachpulse of FIG. 5, the shaded portions out of each pulse waveform of FIG.6 are portions of pulse widths added by the output of random number generator 103.

In order to achieve high accuracy of a differential output waveform, it is necessary that the two pulse signals at the differential waveform are individually central symmetric pulse signals. A specific example is shown in FIG.6.

Numbers 161, 162, 163 and 164 of FIG.6 show segments where the voltage for the two pulse signals is VSS at the differential output waveform for the case where the input value is -1.
In order to satisfy the conditions for high accuracy of the differential output waveform, it is necessary that the time for number 161 and number 162 is equal and the time for number 163 and number 164 is equal, and all differential output waveforms of FIG.6 satisfy this.

The setting conditions and each of the waveforms of FIG.6 are merely an example, and various waveforms can be outputted as differential output waveforms of first output terminal 111 and second output terminal 112 to first output terminal 111 and second output terminal 112 using combinations of various input signals and various outputs of random number generator 103.

Class D amplifier 100 has random intervals between two pulse signals which are differential output waveforms of first output terminal 111 and second output terminal 112, without depending on the input value, and the two pulse widths are not always the same. Namely, in this embodiment, even when the input value is a fixed value or a signal that changes slightly, and, when the two pulse signals which are the differential output signals are consecutively observed, the signals are observed as always fluctuating without predetermined time intervals. As a result, at class D amplifier 100 of this embodiment, the distortion of the specific sampling frequency, the frequency of half of this frequency, and frequencies that are multiples of the frequency appearing in the differential output signal is reduced to a level where the LPF is not required.

On the other hand, when the input value is zero, as shown in FIG.5 and FIG.6, the outputs of first output terminal 111 and second output terminal 112 are fixed at VSS, so that it is possible to achieve less power consumption if the control signal outputs of four switches 115 to 118 of PWM control signal generating circuit 104 are set as fixed values.

When the input value is zero, operation of absolute value generating circuit 135 is stopped by the output of sign determination circuit 134, and calculation operation of adding circuit 138 is stopped by setting the selection values of first selection circuit 136 and second selection circuit 137 as zero. By transmitting a zero determination signal to signal generating circuit 139, the signal generating operation is stopped, and a fixed value for VSS is outputted.

Further, when the input value is other than zero, sign determination circuit 134 switches between selection circuits 136 and 137 so that the selection value of first selection circuit 136 becomes the absolute value outputted from absolute value generating circuit 135 and the selection value for second selection circuit 137 becomes the random value inputted from second input terminal 132. As a result, the addition result of the absolute value of the input value and the random value inputted from second input terminal 132 is outputted to signal generating circuit 139. A random value inputted from second input terminal 132 is also inputted to signal generating circuit 139.

Sign determination circuit 134 determines whether the input value is positive or negative, and outputs a sign identification signal for determining from the result which of first output terminal 111 and second output terminal 112 of output section 120 to have information of the addition result and which to have information of only the random value. Further, a mute signal from mute signal input terminal 133 is also inputted to signal generating circuit 139.

Using the signals and values as generated above, signal generating circuit 139 calculates the positions of rising edges and falling edges of a PWM signal to be outputted by first output terminal 111 and second output terminal 112 from the addition result and random value, determines an initial value and final value at predetermined time intervals, and outputs control signals for four switches 115 to 118 of PWM control signal generating circuit 104 based on these results.

The operation for the case of muting is nowdescribed.

A mute signal inputted to mute signal input terminal 133 directly controls signal generating circuit 139, signal generating circuit 139 receives this mute signal, controls all switches 115 to 118 to be turned off, and makes first output terminal 111 and second output terminal 112 high impedance.

As described above, according to Embodiment 1, class D amplifier 100 is provided with: H (full) bridge output section 120 that has five output states including a fifth output state where the states of first output terminal 111 and second output terminal 112 are both high impedance; and output control section 110 that is configured with random number generator 103 that has individual random numbers that do not depend on the input value as output values, and PWM control signal generating circuit 104 that generates a final PWM control signal from the input value and output values of random number generator 103. Output control section 110 generates a plurality of pulse signals irrelevant to the input value in a random manner using random number generator 103 and PWM control signal generating circuit 104, and outputs a plurality of pulse signals where the total value of pulse widths of the plurality of pulse signals remaining after subtracting another pulse signal from one of the generatedpulse signal has one-to-one relationship with the input value, so that pulse signals outputted at the reference point between sampling frequencies are outputted as a plurality of divided pulse signals with random widths which do not include the reference point. Therefore, the differential output signal is linear with respect to the input, but the pulse period becomes irregular due to the added random pulse widths, and the output signal frequency characteristics have the distortion of the sampling frequency, a frequency of half of this frequency and high frequencies that are multiples of this frequency, reduced to a level where the LPF is not required, so that the LPF is no longer necessary. As a result, it is possible to improve power efficiency and reduce costs. Moreover, circuits shown in FIGs. 3 and 4 can be simply implemented with a combination of a small number of logic elements, counters and the like, and an analog circuit is no longer necessary. As a result, class D amplifier 100 of this embodiment can be implemented with a simple small-scale control circuit.

Further output section 120 of class D amplifier 100 typically adopts a configuration referred to as an H (full) bridge. The most well-known function that is an advantage of an H (full) bridge output section is that it is possible to suppress characteristic power supply noise referred to as regenerative current even when inductive load 150 is connected between first output terminal 111 and second output terminal 112. Class D amplifier 100 of this embodiment has output section 120 referred to as an H (full) bridge, so that, as with other circuits having an H (full) bridge output section, it is possible to suppress characteristic power supply noise referred to as regenerative current even when inductive load 150 is connected.

### (Embodiment 2)

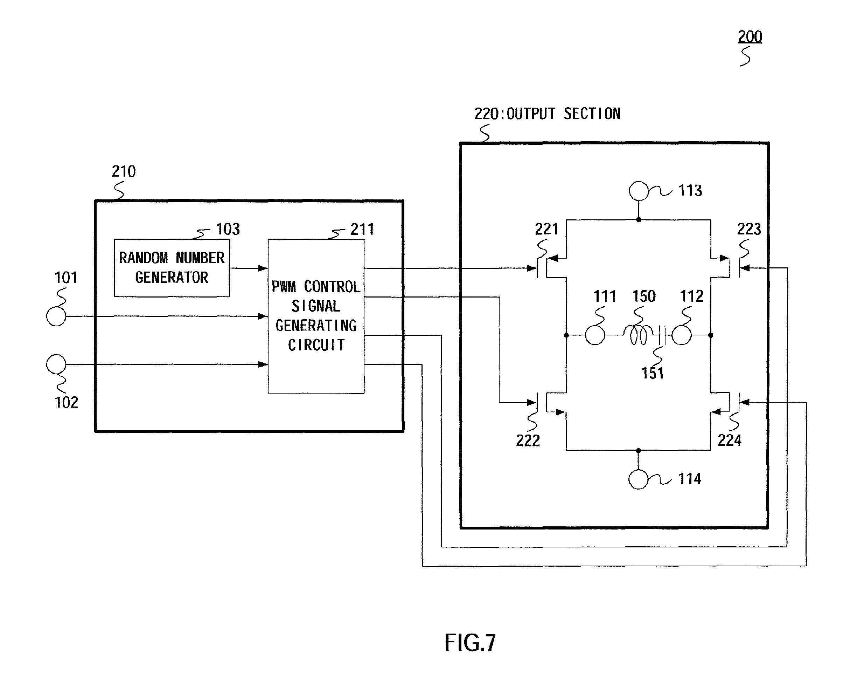

FIG.7 is a circuit diagram showing a configuration of the class D amplifier according to Embodiment 2 of the present invention. In the description of this embodiment, components that are the same as one in FIG.3 are assigned the same reference numerals without further explanations.

In FIG. 7, class D amplifier 200 is configured having: output control section 210 that is configured with input terminal 101, mute signal input terminal 102, random number generator 103 and PWM control signal generating circuit 211; and output section 220 that is configured with first and second output terminals 111 and 112 to which inductive load 150 such as a speaker is connected, first power supply terminal 113 that supplies a first potential, second power supply terminal 114 that supplies a second potential, first PMOS transistor 221 that connects first power supply terminal 113 and first output terminal 111, first NMOS transistor 222 that connects first output terminal 111 and second power supply terminal 114, second PMOS transistor 223 that connects first power supply terminal 113 and second output terminal 112, and second NMOS transistor 224 that connects second output terminal 112 and second power supply terminal 114.

Output section 220 has: first and second P-channel MOS transistors 221 and 223; and first and secondN-channel MOS transistors 222 and 224, wherein: source terminals of first P-channel MOS transistor 221 and second P-channel MOS transistor 223 are connected to the first potential; and source terminals of first N-channel MOS transistor 222 and second N-channel MOS transistor 224 are connected to the second potential, and further has: first output terminal 111 that is provided at a connection point of each of the drains of first P-channel MOS transistor 221 and second P-channel MOS transistor 223; and second output terminal 112 that is provided at a connection point of each of the drains of second P-channel MOS transistor 223 and second N-channel MOS transistor 224.

Class D amplifier 200 is an example using MOS transistors as specific examples of four switches 115 to 118 of class D amplifier 100 shown in FIG.1. Further, the load such as a speaker connected between first output terminal 111 and second output terminal 112 is illustrated as the case of having capacitive load 151 in addition to inductive load 150. Use of MOS transistors 221 to 224 as the above-described switches 115 to 118 are irrelevant to having capacitive load 151 as load, and the load of FIG.7 can be applied to class D amplifier 100 of FIG.3.

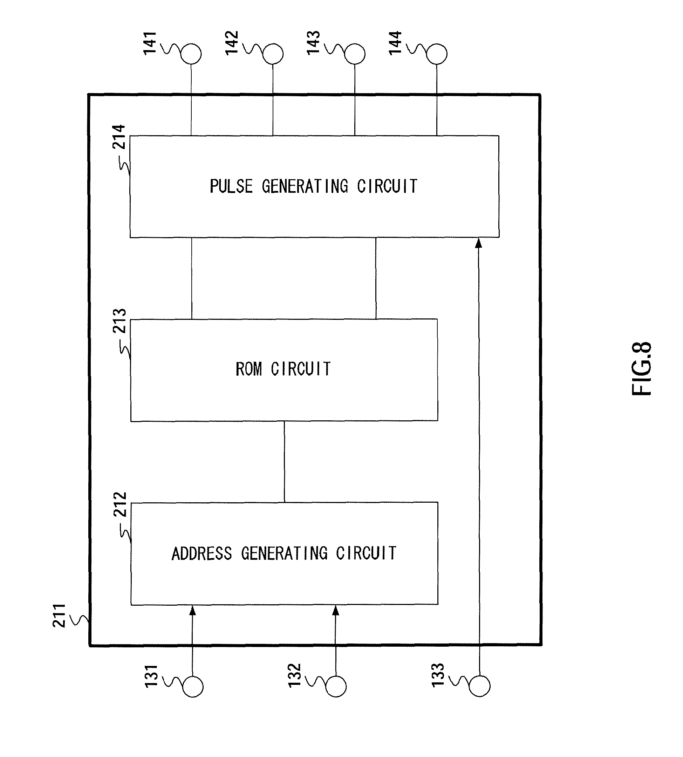

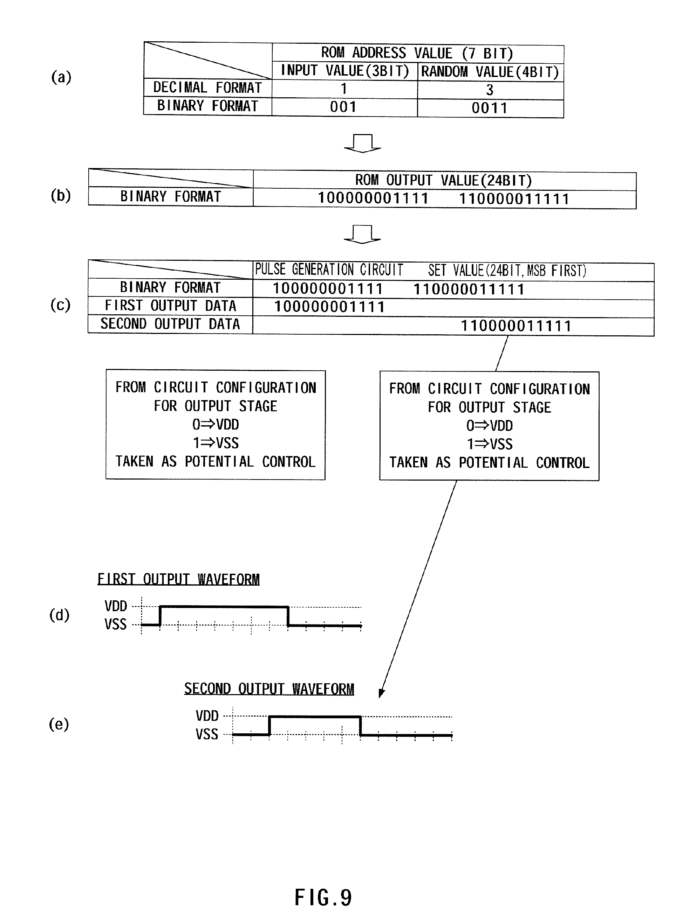

FIG.8 is a block diagram showing a detailed configuration of PWM control signal generating circuit 211 and is an example configured with a ROM etc. Components that are the same as ones in FIG.4 are assigned the same reference numerals. Further, FIG.9 shows an address/output value of the ROM of FIG.8 and an output waveform generated by the address/output value.

In FIG.8, PWM control signal generating circuit 211 is configured having: first input terminal 131 that receives an input value; second input terminal 132 that receives the output of random number generator 103; mute signal input terminal 133; address generating circuit 212 that generates an address signal from an input value and an output value of random number generator 103; ROM circuit 213 that outputs pulse waveform information based on an output value of address generating circuit 212; pulse generating circuit 214 that generates a final PWM control signal based on an output value of ROM circuit 213, and making first output terminal 111 and second output terminal 112 high impedance based on a mute signal; and output terminals 141 to 144 that outputs a generated PWM control signal to MOS transistors 221 to 224.

The input value inputted to first input terminal 131 and the random value inputted to second input terminal 132 are inputted to address generating circuit 212 that determines the address of ROM circuit 213.

The simplest configuration of address generating circuit 212 is a circuit that simply holds the input value of the m bits inputted to first input terminal 131 and the random value for the n bits inputted to second input terminal 132 as an address of (m + n) bits in order of MSB first. This can be configured using just (m + n) flip-flops, and this only operates once per predetermined time interval, so that an extremely simple circuit configuration with little power consumption is possible.

ROM circuit 213 takes the address data of (m + n) bits as input, and outputs control data for pulse generation for first output terminal 111 and control data for pulse generation for second output terminal 112. Further, pulse generating circuit 214 receives control data for pulse generation for ROM circuit 213 and a mute signal inputted to mute signal input terminal 133, and outputs final control data for pulse generation for first output terminal 111 and control data for pulse generation for second output terminal 112.

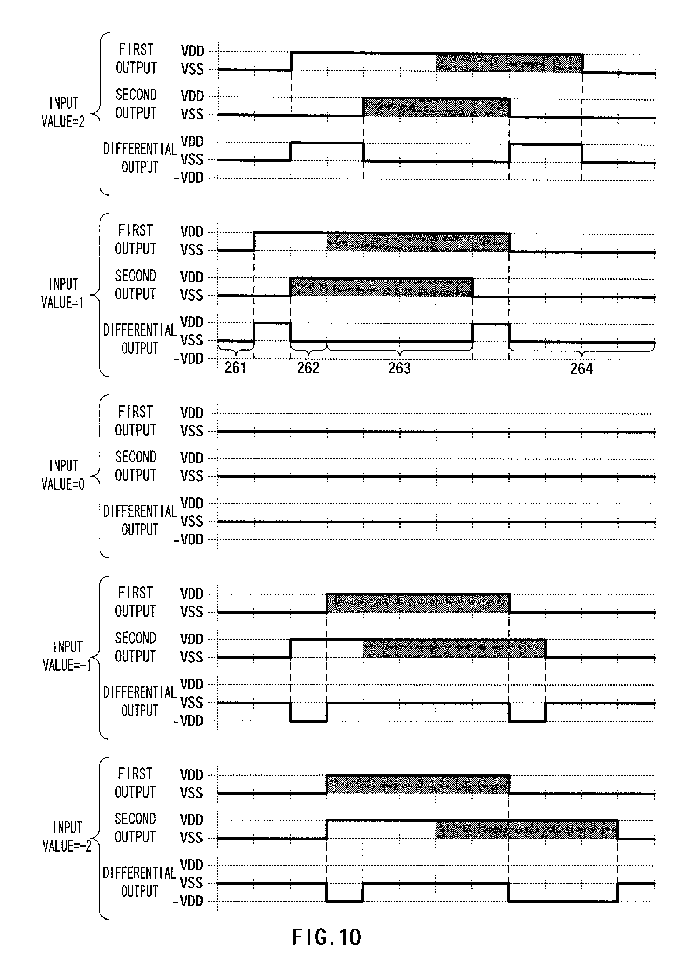

As examples of the simplest configurations of ROM circuit 213 and pulse generating circuit 214, FIGs. 9 (a) and (b) show a value where the ROM address value of ROM circuit 213 is a value of connecting the input value and the random number with MSB first, and FIG. 9 (c) shows data for ROM output set at pulse generating circuit 214. Further, FIGs.9(d) and (e) show an output waveform of first output terminal 111 and an output waveform of second output terminal 112 outputted by pulse generating circuit 214 using the ROM output value. FIG.9 shows an example of the waveform when the input value is two in FIG.10 described later, out of specific examples of values and waveforms of a control signal.

A ROM address value of ROM circuit 213 is a signal of 12 bits made up of, for example, the input value of three bits and random values of nine bits. Further, the output value of ROM circuit 213 is data of twenty bits indicating a signal with which pulse generating circuit 214 controls first output terminal 111 and second output terminal 112. Pulse generating circuit 214 divides the data of twenty bits into an higher-order ten bits and a lower-order ten bits, and performs sequential shift output. This dividing and shift output are possible with a configuration using only a shift register with a set/reset function.

The operation of class D amplifier 200 with the above-described configuration will be described below.

In FIG.7, for example, a speech signal is supplied to PWM control signal generating circuit 211 via input terminal 101 as an input signal. Individual random numbers are then supplied to PWM control signal generating circuit 211 from random number generator 103.

PWM control signal generating circuit 211 has four one-bit signal lines and is capable of individually turning on and off first PMOS transistor 221 first NMOS transistor 222, second PMOS transistor 223 and second NMOS transistor 224 configuring output section 220. These MOS transistors 221 to 224 are connected between the first potential supplied to first power supply terminal 113 and the second potential supplied to second power supply terminal 114.

When first potential VDD is supplied to first power supply terminal 113 and second potential VSS is supplied to second power supply terminal 114, as output states of first output terminal 111 and second output terminal 112 of output section 220, second PWM control signal generating circuit 211 is capable of maintaining the first state where first output terminal 111 and second output terminal 112 are both at VDD, a second state where first output terminal 111 and second output terminal 112 are both at VSS, a third state where first output terminal 111 is at VDD and second output terminal 112 is at VSS, and a fourth state where first output terminal 111 is at VSS and second output terminal 112 is at VDD. When a mute signal is inputted to mute signal input terminal 102, by carrying out control so that all MOS transistors 221 to 224 are turned off, PWM control signal generating circuit 211 can maintain a fifth state where first output terminal 111 and second output terminal 112 are both high-impedance.

In this embodiment, as with Embodiment 1, a description is given in the following with a predetermined time interval, that is at the sampling frequency of 200 kHz, at a clock frequency for PWM indicating resolution of the PWM signal of 2MHz, and setting a central point of the predetermined time interval as a signal reference point so as to be always included in a Hi pulse segment of the pulse signal.

FIG.10 is a signal waveform diagram generated by class D amplifier 200, and is an example of PWM waveforms of first output terminal 111 and second output terminal 112 and differential output waveforms of first output terminal 111 and second output terminal 112 for the case where the input signal supplied to PWM control signal generating circuit 211 via input terminal 101 of class D amplifier 200 changes from -2 to 2.

In each of the pulse waveforms of FIG.10, the arrow portions are delays added by an output of random number generator 103, and the shaded portions are pulse width portions added by the output of random number generator 103.

In order to achieve high accuracy of the differential output waveform, it is necessary that the two pulse signals occurring at the differential waveform are individually central symmetric pulse signals.

Numbers 261, 262, 263 and 264 of FIG. 10 show segments where the voltage for the two pulse signals is VSS at the differential output waveform for the case where the input value is -1. In order to satisfy the conditions to achieve high accuracy of the differential output waveform, it is necessary that the time for number 261 and number 262 is equal and the time for number 261 and number 264 is equal, and all differential output waveforms of FIG.10 satisfy this.

The setting conditions and the waveforms of FIG.10 are merely an example, and various waveforms can be outputted as first output terminal 111 and second output terminal 112 and as differential output waveforms for first output terminal 111 and second output terminal 112 by combinations of various input signals and various outputs of random number generator 103.

Class D amplifier 200 has random intervals between two pulse signals which are differential output waveforms of first output terminal 111 and second output terminal 112, without depending on the input value, and the two pulse widths are not always the same. Namely, in this embodiment, even when the input value is a fixed value or a signal that changes slightly, when the two pulse signals which are the differential output signals are consecutively observed, the signals are observed as always fluctuating without predetermined time intervals. As a result, at class D amplifier 200 of this embodiment, the distortion of the specific sampling frequency, the frequency of half of this frequency, and frequencies that are multiples of the frequency, appearing in the differential signal is reduced to a level where the LPF is not required.

The operation for the case of muting is nowdescribed.

In the case of muting, a mute signal is inputted to mute signal input terminal 133 and becomes a set signal for the shift register of pulse generating circuit 214. During the set signal for the shift register of pulse generating circuit 214, a control signal turning off all MOS transistors 221 to 224 is outputted from pulse generating circuit 214. As a result, first output terminal 111 and second output terminal 112 both become high impedance.

As described above, according to Embodiment 2, by usingMOS transistors 221 to 224 at first to fourth switches of output section 220 configuring an H-bridge, a specific configuration of output section 220 of class D amplifier 200 is shown. Further, it is also shown that the load may include capacitive load 151. It is possible to provide the same advantages as in Embodiment 1 in this embodiment, that is, even when the input value is a fixedvalue or signal that changes slightly, implementation using a simple and small-scale control circuit is possible, and, when the pulse signals which are the differential output signals are consecutively observed, the signals are observed as always fluctuating without predetermined intervals, and the pulse widths are observed as always fluctuating. As a result, it is possible to reduce the distortion of the specific sampling frequency, the frequency of half of this frequency, and frequencies that are multiples of this frequency, appearing in the differential output signal to a level where the LPF is not required.

Further, output section 220 has an H (full) bridge circuit configuration, so that it is possible to suppress characteristic noise referred to as regenerative current even if inductive load 150 and capacitive load 151 are connected between first output terminal 111 and second output terminal 112.

Moreover, in this embodiment, PWM control signal generating circuit 211 is configured with address generating circuit 212, ROM circuit 213 and pulse generating circuit 214, so that it is possible to operate at high speed, and readily change design using various specifications. Further, as in Embodiment 1, the circuit can be readily implemented with a combination of a small number of logic elements and flip-flops etc., and an analog circuit is not required, so that implementation with a simple and small-scale control circuit is possible.

In this embodiment, a case has been described as an example where PWM control signal generating circuit 211 is configured with address generating circuit 212, ROM circuit 213 and pulse generating circuit 214, but PWM control signal generating circuit 211 may have a circuit configuration as shown in FIG.4 of Embodiment 1, and the same operation is possible.
Therefore, a designer can select a specific configuration of the PWM control signal generating circuit 211 according to design specifications and purpose.
Similarly, output section 220 can be configured with switches 115 to 118 shown in FIG. 3, or other FET transistors and bipolar transistors etc. having the same switch function.

### (Embodiment 3)

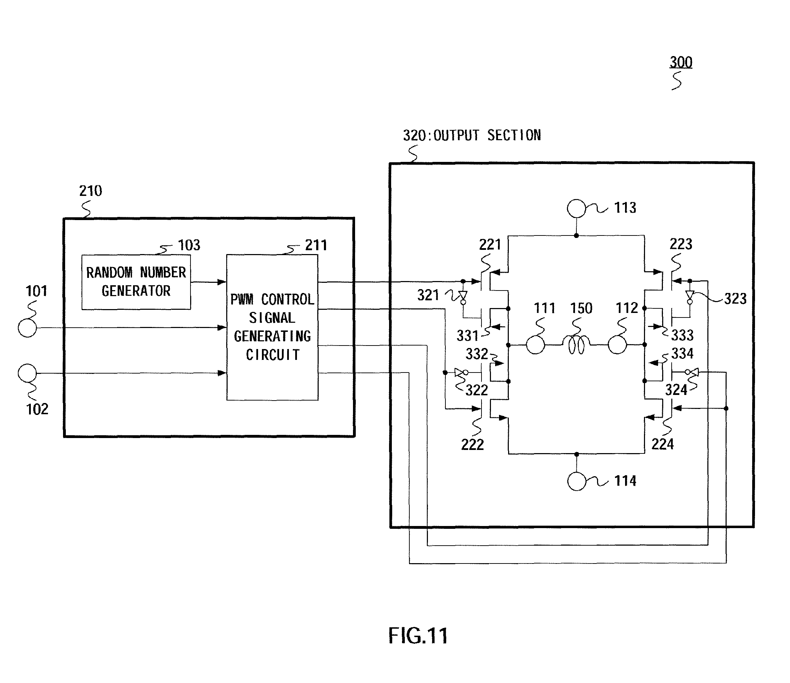

FIG.11 is a circuit diagram showing a configuration of the D class amplifier of Embodiment 3 of the present invention.

In the description of this embodiment, components that are the same as ones in FIG.7 are assigned the same reference numerals without further explanations.

In FIG.11, class D amplifier 300 is configured having: output control section 210 that is configured with input terminal 101, mute signal input terminal 102, random number generator 103 and PWM control signal generating circuit 211; and output section 320 that is configured with first and second output terminals 111 and 112 to which inductive load 150 such as a speaker is connected, first power supply terminal 113 that supplies a first potential, second power supply terminal 114 that supplies a second potential, first PMOS transistor 221 that connects first power supply terminal 113 and first output terminal 111, first NMOS transistor 222 that connects first output terminal 111 and second power supply terminal 114, second PMOS transistor 223 that connects first power supply terminal 113 and second output terminal 112, second NMOS transistor 224 that connects second output terminal 112 and second power supply terminal 114, inverter 321 that inverts a signal applied to first PMOS transistor 221, third PMOS transistor 331 that receives an output of inverter 321 at a gate so that the source is in a floating state, inverter 322 inverting a signal applied to the first NMOS transistor 222, third MOS transistor 332 receiving an output of inverter 322 at a gate so that a source is in a floating state, inverter 323 that inverts a signal applied to second PMOS transistor 223, fourth PMOS transistor 333 that receives an output of inverter 323 at a gate so that a source is in a floating state, inverter 324 that inverts a signal applied to the second NMOS transistor 224, and fourth MOS transistor 334 that receives an output of inverter 324 so that a source is in a floating state.

In addition to the circuit configuration of output section 220 of class D amplifier 200 shown in FIG.7, output section 320 of class D amplifier 300 is configured adding: third P-channel MOS transistor 331 where a drain is connected to first output terminal 111, an inverted signal of the signal to be applied to first P-channel MOS transistor 221 inverted by inverter 321 is applied to a gate, a source is in a floating state, and the channel width is the same size as the channel width of first P-channel MOS transistor 221; third N-channel MOS transistor 332 where a drain is connected to first output terminal 111, an inverted signal of the signal to be applied to first N-channel MOS transistor 222 inverted by inverter 322 is applied to a gate, a source is in a floating state, and the channel width is the same size as the channel width of first N-channel MOS transistor 222; fourth P-channel MOS transistor 333 where a drain is connected to second output terminal 112, an inverted signal of the signal to be applied to second P-channel MOS transistor 223 inverted by inverter 323 is applied to a gate, a source is in a floating state, and the channel width is the same size as the channel width of second P-channel MOS transistor 223; and fourth N-channel MOS transistor 334 where a drain is connected to second output terminal 112, an inverted signal of the signal to be applied to second N-channel MOS transistor 224 inverted by inverter 324 is applied to a gate, a source is in a floating state, and the channel width is the same size as the channel width of second N-channel MOS transistor 224.

As in Embodiment 2, the load such as a speaker connected between first output terminal 111 and second output terminal 112 may also include capacitive load 151 in addition to inductive load 150. Further, in this embodiment, output control section 210 of Embodiment 2 is used at the output control section of class D amplifier 300, but it is possible to apply output control section 110 of Embodiment 1.

The operation of class D amplifier 300 with the above-described configuration will be described. The basic operation is the same as Embodiment 2, and therefore description is simplified, and only different operation will be described in detail.

In FIG.11, for example, a speech signal is supplied to PWM control signal generating circuit 211 via input terminal 101 as an input signal.
Individual random numbers are then supplied to PWM control signal generating circuit 211 from random number generator 103.

PWM control signal generating circuit 211 has four one-bit signal lines and is capable of individually turning on and off first PMOS transistor 221 first NMOS transistor 222, second PMOS transistor 223 and second NMOS transistor 224 configuring output section 320. These MOS transistors 221 to 224 are connected between the first potential supplied to first power supply terminal 113 and the second potential supplied to second power supply terminal 114.

When first potential VDD is supplied to first power supply terminal 113 and second potential VSS is supplied to second power supply terminal 114, as output states of first output terminal 111 and second output terminal 112 of output section 320, PWM control signal generating circuit 211 is capable of maintaining a first state where first output terminal 111 and second output terminal 112 are both at VDD, a second state where first output terminal 111 and second output terminal 112 are both at VSS, a third state where first output terminal 111 is at VDD and second output terminal 112 is at VSS, and a fourth state where first output terminal 111 is at VSS and second output terminal 112 is at VDD. When a mute signal is inputted to mute signal input terminal 102, PWM control signal generating circuit 211 maintains a fifth state where first output terminal 111 and second output terminal 112 are both high-impedance by carrying out control so that all MOS transistors 221 to 224 are turned off.

In this embodiment, as with Embodiments 1 and 2, a description is given in the following with a predetermined time interval, that is, at the sampling frequency of 200 kHz, at a clock frequency for PWM indicating resolution of the PWM signal of 2 MHz, and setting a central point of the predetermined time interval as a signal reference point so as to be always included in a Hi pulse segment of the pulse signal. There are two main points for achieving high accuracy of the output signals outputted by first output terminal 111 and second output terminal 112 in this embodiment.

Firstly, by adopting an H (full) bridge, it is also possible to suppress characteristic power supply noise referred to as regenerative current generated by inductive load 150 between first output terminal 111 and second output terminal 112. Output section 320 of class D amplifier 300 of FIG.11 has an H (full) bridge circuit configuration, so that it is possible to avoid characteristic power supply noise referred to as regenerative current.

Secondly, by adopting a MOS transistor, feed through noise is eliminated. A parasitic capacitance of a size proportional to the gate width exists between the gate and drain at the drain portion of the MOS transistor. When there is a potential change at both ends of the parasitic capacitance, the charge is charged and discharged, and the charging and discharging of this charge appears on the signal as noise. This noise is typically referred to as feed through noise.

Specifically, when first PMOS transistor 221 is on and first output terminal 111 is VDD as, for example, in the first state and the third state, the drain--first output terminal 111--is VDD, and the gate potential is VSS. As a result, the potential difference between the drain and gate is equal to (VDD - VSS). At this time, a charge proportional to (VDD - VSS) is charged to the parasitic capacitance between the gate and drain.

Next, the case is considered where the state of first PMOS transistor 221 changes to the second state or the fourth state.
The potential difference between the drain and gate of PMOS transistor 221 after changing becomes (VSS - VDD). Namely, there is a potential change of two times of (VDD - VSS) before and after this change.
In order to reduce feed through noise generated due to this potential change, it is only necessary to connect the drain of third PMOS transistor 331 with the same size and parasitic capacitance between the gate and the drain as first PMOS transistor 221 and subjected to control of the reverse polarity to that for first PMOS transistor 221, to the drain of first PMOS transistor 221. According to this circuit configuration, first, the parasitic capacitance values of first PMOS transistor 221 and third PMOS transistor 331 are equal, the sum of the potential difference (VDD - VSS) between the drain and gate of first PMOS transistor 221 and the potential difference (VSS - VDD) between the drain and gate of the third PMOS transistor 331 is always zero, and the feed through noise also becomes zero through calculation, so that it is possible to substantially improve the characteristics of the feed through noise. The operation and improved effects are the same for all other MOS transistors configuring output section 320.

Further, the only difference with Embodiment 2 is the configuration of output section 320. It can be easily understood that input terminal 101, PWM control signal generating circuits 104 and 211, random number generator 103, and mute signal input terminal 102 used in Embodiments 1 and 2 can be used as is in class D amplifier 300 of this embodiment, and the differential output waveforms of first output terminal 111 and second output terminal 112 can also be obtained as in Embodiments 1 and 2.

Class D amplifier 300 of this embodiment has random intervals between two pulse signals which are the differential output waveforms of first output terminal 111 and second output terminal 112, without depending on the input value, and the two pulse widths are not always the same. Namely, in this embodiment, even when the input value is a fixed value or a signal that changes slightly, when the two pulse signals which are the differential output signals are consecutively observed, the signals are observed as always fluctuating without predetermined time intervals. As a result, in class D amplifier 300 of this embodiment, it is possible to reduce the distortion of the specific sampling frequency, the frequency of half of this frequency, and frequencies that are multiples of this frequency, appearing at the differential output signal to a level where the LPF is not required, and, even when inductive load 150 is connected between first output terminal 111 and second output terminal 112, it is possible to suppress characteristic power supply noise referred to as regenerative current and substantially reduce the feed through noise generated as a result of configuring output section 320 using MOS transistors.

As described above, according to Embodiment 3, output section 320 is further configured with third PMOS transistor 331, third MOS transistor 332, fourth PMOS transistor 333 and fourth MOS transistor 334 where inverted signals are applied to the gates of first PMOS transistor 221, first NMOS transistor 222, second PMOS transistor 223 and second NMOS transistor 224, so that in addition to the advantages of Embodiments 1 and 2, feed through noise is calculated as zero, and it is possible to substantially improve characteristics of the feed through noise.

### (Embodiment 4)

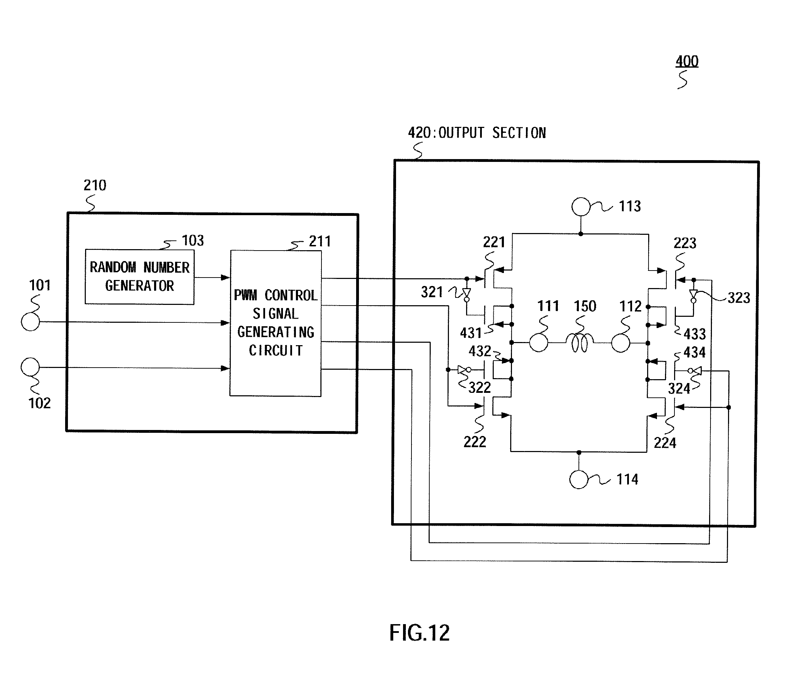

FIG. 12 is a circuit diagram showing a configuration of the class D amplifier according to Embodiment 4 of the present invention. In the description of this embodiment, components that are the same as ones in FIG.11 are assigned the same reference numerals without further explanations.

In FIG.12, class D amplifier 400 is configured having: output control section 210 that is configured with input terminal 101, mute signal input terminal 102, random number generator 103 and PWM control signal generating circuit 211; and output section 420. Output section 420 is provided with: first and second output terminals 111 and 112 to which inductive load 150 such as a speaker is connected; first power supply terminal 113 that supplies a first potential, second power supply terminal 114 that supplies a second potential; first PMOS transistor 221 that connects first power supply terminal 113 and first output terminal 111; first NMOS transistor 222 that connects first output terminal 111 and second power supply terminal 114; second PMOS transistor 223 that connects first power supply terminal 113 and second output terminal 112; second NMOS transistor 224 that connects second output terminal 112 and second power supply terminal 114. Output section 420 is further provided with: inverter 321 that inverts a signal applied to first PMOS transistor 221; third PMOS transistor 431 that has a half size of first PMOS transistor 221, wherein a drain and source are connected to the drain of first PMOS transistor 221, and a gate receives a control signal with a reverse polarity to a control signal applied to a gate of first PMOS transistor 221; inverter 322 that inverts a signal applied to first NMOS transistor 222; third NMOS transistor 432 that has a half size of first NMOS transistor 222, wherein a drain and source are connected to the drain of first NMOS transistor 222, and a gate receives a control signal with a reverse polarity to a control signal applied to a gate of first NMOS transistor 222; inverter 323 that inverts a signal applied to second PMOS transistor 223; fourth PMOS transistor 433 that has a half size of second PMOS transistor 223, wherein a drain and source are connected to the drain of second PMOS transistor 223, and a gate receives a control signal with a reverse polarity to a control signal applied to a gate of second PMOS transistor 223; inverter 324 that inverts a signal applied to second NMOS transistor 224; and fourth NMOS transistor 434 that has a half size of second NMOS transistor 224, wherein a drain and source are connected to the drain of second NPMOS transistor 224, and a gate receives a control signal with a reverse polarity to a control signal applied to a gate of second NMOS transistor 224.

In addition to the circuit configuration of output section 220 of class D amplifier 200 shown in FIG.7, output section 420 of class D amplifier 400 is further configured adding: third P-channel MOS transistor 431 where a source and drain are connected to first output terminal 111, an inverted signal of the signal to be applied to first P-channel MOS transistor 221 is applied to a gate, and a channel width is a half of the channel width of first P-channel MOS transistor 221; third N-channel MOS transistor 432 where a source and drain are connected to first output terminal 111, an inverted signal of the signal to be applied to first N-channel MOS transistor 222 is applied to a gate, and a channel width is a half of the channel width of first N-channel MOS transistor 222; fourth P-channel MOS transistor 433 where a source and drain are connected to second output terminal 112, an inverted signal of the signal to be applied to second P-channel MOS transistor 223 is applied to a gate, and a channel width is a half of the channel width of second P-channel MOS transistor 223; and fourth N-channel MOS transistor 434 where a source and drain are connected to second output terminal 112, an inverted signal of the signal to be applied to second N-channel MOS transistor 224 is applied to a gate, and a channel width is a half of the channel width of second N-channel MOS transistor 224.

As in Embodiment 2, the load such as a speaker connected between first output terminal 111 and second output terminal 112 may also include capacitive load 151 in addition to inductive load 150.
Further, in this embodiment, output control section 210 of Embodiment 2 is used at the output control section of class D amplifier 400, but it is also possible to apply output control section 110 of Embodiment 1.

The operation of class D amplifier 400 with the configuration described above will be described. The basic operation is the same as Embodiment 3, and description is therefore simplified, and only different operation will be described in detail.

In FIG.12, for example, a speech signal is supplied to PWM control signal generating circuit 211 via input terminal 101 as an input signal. Individual random numbers are then supplied to PWM control signal generating circuit 211 from random number generator 103.

PWM control signal generating circuit 211 has four one-bit signal lines and is capable of individually turning on and off first PMOS transistor 221, first NMOS transistor 222, second PMOS transistor 223 and second NMOS transistor 224 configuring output section 420. These MOS transistors 221 to 224 are connected between the first potential supplied to first power supply terminal 113 and the second potential supplied to second power supply terminal 114.

When first potential VDD is supplied to first power supply terminal 113 and second potential VSS is supplied to second power supply terminal 114, as output states of first output terminal 111 and second output terminal 112 of output section 420, second PWM control signal generating circuit 211 is capable of maintaining a first state where first output terminal 111 and second output terminal 112 are both at VDD, a second state where first output terminal 111 and second output terminal 112 are both at VSS, a third state where first output terminal 111 is at VDD and second output terminal 112 is at VSS, and a fourth state where first output terminal 111 is at VSS and second output terminal 112 is at VDD. When a mute signal is inputted to mute signal input terminal 102, PWM control signal generating circuit 211 maintains a fifth state where first output terminal 111 and second output terminal 112 are both high impedance by carrying out control so that all MOS transistors 221 to 224 are turned off.

In this embodiment, as with Embodiments 1 to 3, a description is given in the following with a predetermined time interval, that is, at the sampling frequency of 200 kHz, at a clock frequency for PWM indicating resolution of the PWM signal of 2 MHz, and setting a central point of the predetermined time interval as a signal reference point so as to be always included in a Hi pulse segment of the pulse signal.

There are two main points for achieving high accuracy of the output signals outputted by first output terminal 111 and second output terminal 112 in this embodiment.

Firstly, by adopting an H (full) bridge, it is also possible to suppress characteristic power supply noise referred to as regenerative current generated by inductive load 150 between first output terminal 111 and second output terminal 112. Output section 320 of class D amplifier 300 of FIG.11 has an H (full) bridge circuit configuration, so that it is possible to avoid characteristic power supply noise referred to as regenerative current.

Secondly, by adopting a MOS transistor, feed through noise is eliminated.
A parasitic capacitance of a size proportional to the gate width exists between the gate and drain at the drain portion of the MOS transistor. When there is a change in potential at both ends of the parasitic capacitance, the charge is charged and discharged, the charging and discharging of this charge appears on the signal as noise, that is, feed through noise is generated.

Specifically, when first PMOS transistor 221 is on and first output terminal 111 is VDD as, for example, in the first state and the third state, the drain--first output terminal 111--is VDD, and the gate potential is VSS. As a result, the potential difference between the drain and gate is equal to (VDD - VSS). At this time, a charge proportional to (VDD - VSS) is charged to the parasitic capacitance between the gate and drain.

Next, the case is considered where the state of first PMOS transistor 221 changes to the second state or the fourth state. The potential difference between the drain and gate of PMOS transistor 221 after changing becomes (VSS - VDD). Namely, there is a potential change of two times of (VDD - VSS) before and after this change. In order to reduce feed through noise generated due to this potential change, in Embodiment 3, as shown in FIG.11, third PMOS transistor 331 is used that is the same size as first PMOS transistor 221 and has equal parasitic capacitance between the gate and the drain, and subjected to control of the reverse polarity to first PMOS transistor 221.
However, by focusing on the fact that , from a typical structure of a MOS transistor, parasitic capacitance between the gate and source is substantially equal to parasitic capacitance between the gate and drain, if a configuration is adopted where both source and drain are connected to the drain of first PMOS transistor 221, the transistor width of third PMOS transistor 431 necessary for reducing field through noise may be half of the transistor width of first PMOS transistor 221, so that it is possible to miniaturize the circuit. According to this circuit configuration, first, the parasitic capacitance values of first PMOS transistor 221 and third PMOS transistor 431 are equal, and the sum of the potential difference (VDD - VSS) between the drain and gate of first PMOS transistor 221 and the potential difference (VSS - VDD) between the drain and gate of the third PMOS transistor 431 is zero, and the feed through noise also becomes zero in calculation, so that it is possible to substantially improve the characteristics of feedt hrough noise. The operation and improved effects are the same for all other MOS transistors configuring output section 420.

Further, the only difference with Embodiment 2 is the configuration of output section 420. Therefore, it can be easily understood that it is possible to use input terminal 101, PWM control signal generating circuits 104 and 211, random number generator 103, and mute signal input terminal 102 used in Embodiments 1 and 2 as is in class D amplifier 300 of this embodiment, and obtain the differential output waveforms of first output terminal 111 and second output terminal 112 as in the Embodiments 1 and 2.

Class D amplifier 400 of this embodiment has random intervals between two pulse signals which are the differential output waveforms of first output terminal 111 and second output terminal 112, without depending on the input value, and the two pulse widths are not always the same. Namely, in this embodiment, even when the input value is a fixed value or a signal that changes slightly, and, when the two pulse signals which are the differential output signals are consecutively observed, the signals are observed as always fluctuating without predetermined time intervals. As a result, with class D amplifier 400 of this embodiment, it is possible to suppress the distortion of the specific sampling frequency, the frequency of half of this frequency, and frequencies that are multiples of this frequency, appearing at the differential output signal to a level where the LPF is not required, suppress characteristic power supply noise referred to as regenerative current even when inductive load 150 is connected between first output terminal 111 and second output terminal 112, substantially reduce feed through noise generated as a result of configuring output section 420 using MOS transistors, and miniaturize the circuit.

As described above, according to Embodiment 4, with respect to first PMOS transistor 221, first NMOS transistor 222, second PMOS transistor 223 and second NMOS transistor 224, output section 420 is further configured with: third PMOS transistor 431 that has a half size of first PMOS transistor 221, wherein a drain and source are connected to the drain of first PMOS transistor 221, and a gate receives a control signal with a reverse polarity to a control signal applied to a gate of first PMOS transistor 221; third NMOS transistor 432 that has a half size of first NMOS transistor 222, wherein a drain and source are connected to the drain of first NMOS transistor 222, and a gate receives a control signal with a reverse polarity to a control signal applied to agateof first NMOS transistor 222; fourth PMOS transistor 433 that has a half size of second PMOS transistor 223, wherein a drain and source are connected to the drain of second PMOS transistor 223, and a gate receives a control signal with a reverse polarity to a control signal applied to a gate of second PMOS transistor 223; and fourth NMOS transistor 434 that has a half size of second NMOS transistor 224, wherein a drain and source are connected to the drain of second NPMOS transistor 224, and a gate receives a control signal with a reverse polarity to a control signal applied to a gate of second NMOS transistor 224. Therefore, in addition to the advantage of reducing feed through noise of Embodiment 3, transistor width of the added MOS transistor is half, so that it is possible to miniaturize the circuit.

### (Embodiment 5)

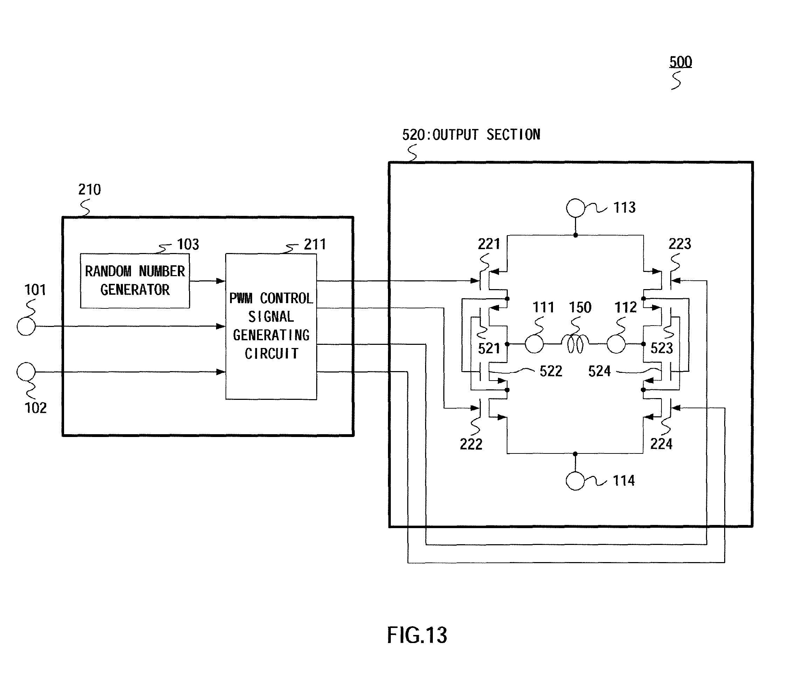

FIG.13 is a circuit diagram showing a configuration of the class D amplifier of Embodiment 5 of the present invention.

In the description of this embodiment, components that are the same as ones in FIG.7 are assigned the same reference numerals without further explanations.

In FIG.13, class D amplifier 500 is configured having: output control section 210 configured with input terminal 101, mute signal input terminal 102, random number generator 103 and PWM control signal generating circuit 211; and output section 520. Output section is provided with: first and second output terminals 111 and 112 to which inductive load 150 such as a speaker is connected; first power supply terminal 113 that supplies a first potential; second power supply terminal 114 that supplies a second potential, first PMOS transistor 221 that connects the first power supply terminal 113 and the first output terminal 111; first NMOS transistor 222 that connects first output terminal 111 and second power supply terminal 114; second PMOS transistor 223 that connects first power supply terminal 113 and second output terminal 112; second NMOS transistor 224 that connects second output terminal 112 and second power supply terminal 114; fifth P-channel MOS transistor 521 where a source is connected to the drain of first P-channel MOS transistor 221, a gate is connected to the drain of first N-channel MOS transistor 222, and a drain is connected to first output terminal 111; fifth N-channel MOS transistor 522 where a source is connected to the drain of first N-channel MOS transistor 222, a gate is connected to the drain of first P-channel MOS transistor 221, and a drain is connected to first output terminal 111; sixth P-channel MOS transistor 523 where a source is connected to the drain of second P-channel MOS transistor 223, a gate is connected to the drain of second N-channel MOS transistor 224, and a drain is connected to second output terminal 112; and sixth N-channel MOS transistor 524 where a source is connected to the drain of secondN-channel MOS transistor 224, a gate is connected to the drain of second N-channel MOS transistor 224, and a drain is connected to second output terminal 112.

As in Embodiment 2, the load such as a speaker connected between first output terminal 111 and second output terminal 112 may also include capacitive load 151 in addition to inductive load 150. Further, in this embodiment, output control section 210 of Embodiment 2 is used at the output control section of class D amplifier 500, but it is also possible to applyoutput control section 110 of Embodiment 1.

The operation of class D amplifier 500 with the above-described configuration will be described. The basic operation is the same as Embodiment 2, and therefore description is simplified, and only the different operation will be described in detail.

In FIG.13, for example, a speech signal is supplied to PWM control signal generating circuit 211 via input terminal 101 as an input signal. Individual random numbers are then supplied to PWM control signal generating circuit 211 from random number generator 103.

PWM control signal generating circuit 211 has four one-bit signal lines and is capable of individually turning on and off first PMOS transistor 221, first NMOS transistor 222, second PMOS transistor 223 and second NMOS transistor 224 configuring output section 520.

Further, it is provided with: fifth P-channel MOS transistor 521 where a source is connected to the drain of first P-channel MOS transistor 221, a gate is connected to the drain of first N-channel MOS transistor 222, and a drain is connected to first output terminal 111; fifth N-channel MOS transistor 522 where a source is connected to the drain of first N-channel MOS transistor 222, a gate is connected to the drain of first P-channel MOS transistor 221, and a drain is connected to first output terminal 111; sixth P-channel MOS transistor 523 where a source is connected to the drain of second P-channel MOS transistor 223, a gate is connected to the drain of second N-channel MOS transistor 224, and a drain is connected to second output terminal 112; and sixth N-channel MOS transistor 524 where a source is connected to the drain of second N-channel MOS transistor 224, a gate is connected to the drain of second N-channel MOS transistor 224, and a drain is connected to second output terminal 112.

These MOS transistors 221 to 224 are connected between the first potential supplied to first power supply terminal 113 and the second potential supplied to second power supply terminal 114.

When first potential VDD is supplied to first power supply terminal 113 and second potential VSS is supplied to second power supply terminal 114, as output states of first output terminal 111 and second output terminal 112 of output section 220, second PWM control signal generating circuit 211 is capable of maintaining the first state where first output terminal 111 and second output terminal 112 are both at VDD, a second state where first output terminal 111 and second output terminal 112 are both at VSS, a third state where first output terminal 111 is at VDD and second output terminal 112 is at VSS, and a fourth state where first output terminal 111 is at VSS and second output terminal 112 is at VDD. When a mute signal is inputted to mute signal input terminal 102, PWM control signal generating circuit 211 maintains a fifth state where first output terminal 111 and second output terminal 112 are both high-impedance by carrying out control so that all MOS transistors 221 to 224 are turned off.

In this embodiment, as with Embodiments 1 to 4, a description is given in the following with a predetermined time interval, that is, at the sampling frequency of 200 kHz, at a clock frequency for PWM indicating resolution of the PWM signal of 2 MHz, and setting a central point of the predetermined time interval as a signal reference point so as to be always included in a Hi pulse segment of the pulse signal.

As with Embodiment 3, there are two main points for achieving high accuracy of the output signals outputted by first output terminal 111 and second output terminal 112 in this embodiment.

Firstly, by adopting an H (full) bridge, it is also possible to suppress characteristic power supply noise referred to as regenerative current generated by inductive load 150 between first output terminal 111 and second output terminal 112. Output section 520 of class D amplifier 500 of FIG.13 has an H (full) bridge circuit configuration, so that it is possible to avoid characteristic power supply noise referred to as regenerative current. Further, at the output terminals of first output terminal 111 and second output terminal 112, directly after the change in potential state and at the end of the change, fifth PMOS transistor 521, fifth NMOS transistor 522, sixth PMOS transistor 523, and sixth NMOS transistor 524 are in a non-saturated state and may be regarded as resistance elements that have diode characteristics, so that it is possible to further improve the effect of reducing power supply noise due to heat consumption of the regenerative current that is a characteristic of an H (full) bridge.

Secondly, in output section 520 of class D amplifier 500 of this embodiment, instead of using compensation of charge by the capacitance, by using the fact that fifth PMOS transistor 521, fifth NMOS transistor 522, sixth PMOS transistor 523 and sixth NMOS transistor 524 have characteristics as resistance elements having diode characteristics in non-saturated states directly after the change of the potential state, during the change, and at the end of the change, it is possible to reduce the field through noise. This is described in detail in the following.

The potential change between the gate and drain of first PMOS transistor 221 generates charge that charges and discharges the parasitic capacitance, the charge is superimposed on the output signal and appears, and thereby the field through noise is generated. However, out of the circuits of this embodiment, for example, the current due to the change between the gate and drain of first PMOS transistor 221 is substantially attenuated before reaching first output terminal 111 and consumed as heat, since fifth PMOS transistor 521 can be regarded as a resistance element having a diode characteristic.

Further, the characteristic as a resistance element having a diode characteristic directly after the change in the potential state and at the end of the change, alleviates overshooting and undershooting before and after the potential change of the pulse waveform, alleviates ringing, and can also be used for adjustment of slew rate during the change in the potential state. Therefore, it is possible to readily reduce consumption of the current of the operation current of output section 520.

Further, the difference with Embodiment 2 is only the configuration of output section 520. Therefore, it can be easily understood that it is possible to use input terminal 101, PWM control signal generating circuits 104 and 211, random number generator 103, and mute signal input terminal 102 used in Embodiments 1 and 2 as is in class D amplifier 500 of this embodiment, and obtain the differential output waveforms of first output terminal 111 and second output terminal 112 as in Embodiments 1 and 2.

Class D amplifier 500 of this embodiment has random intervals between two pulse signals which are the differential output waveforms of first output terminal 111 and second output terminal 112, without depending on the input value, and the two pulse widths are not always the same. Namely, in this embodiment, even when the input value is a fixed value or a signal that changes slightly, and when the two pulse signals which are the differential output signals are consecutively observed, the signals are observed as always fluctuating without predetermined time intervals. As a result, with class D amplifier 500 of this embodiment, it is possible to reduce the distortion of the specific sampling frequency, the frequency of half of this frequency, and frequencies that are multiples of this frequency, appearing at the differential output signal to a level where the LPF is not required, suppress characteristic power supply noise referred to as regenerative current even when inductive load 150 is connected between first output terminal 111 and second output terminal 112, and further, substantially reduce feed through noise generated as a result of configuring output section 520 using MOS transistors, overshooting, undershooting and ringing, miniaturize the circuit, and reduce power consumption.

As described above, according to Embodiment 5, with respect to first PMOS transistor 221, first NMOS transistor 222, second PMOS transistor 223, and second NMOS transistor 224, output section 520 is further configured with: fifth P-channel MOS transistor 521 where a source is connected to the drain of first P-channel MOS transistor 221, a gate is connected to the drain of first N-channel MOS transistor 222, and a drain is connected to first output terminal 111; fifth N-channel MOS transistor 522 where a source is connected to the drain of first N-channel MOS transistor 222, a gate is connected to the drain of first P-channel MOS transistor 221, and a drain is connected to first output terminal 111; sixth P-channel MOS transistor 523 where a source is connected to the drain of second P-channel MOS transistor 223, a gate is connected to the drain of second N-channel MOS transistor 224, and a drain is connected to second output terminal 112; and sixth N-channel MOS transistor 524 where a source is connected to the drain of secondN-channelMOS transistor 224, a gate is connected to the drain of second N-channel MOS transistor 224, and a drain is connected to second output terminal 112. Therefore, in addition to the advantages of Embodiments 1 and 2, by using MOS transistors 521 to 524 in non-saturated states, it is possible to regard them as resistance elements having diode characteristics and improve the effect of reducing power supply noise due to heat consumption of the regenerative current. Further, by having the characteristic as a resistance element having a diode characteristic, overshooting and undershooting before and after the change in the potential of the pulse waveform is alleviated, ringing is alleviated, and it is also possible to be used for adjustment of slew rate during the change in the potential state, so that it is possible to readily reduce consumption of the current of the operation current of output section 520.

### (Embodiment 6)

In each of the embodiments described above, an example has been described of power amplifying a given speech signal using switching operation and supplying the result to a load such as a speaker. It is also possible to adaptively use any of the class D amplifiers according to the above-described embodiments for a plurality of speech signals. In Embodiment 6, an example will be described where a plurality of speech signals are inputted as input signals, such as a stereo equipment.

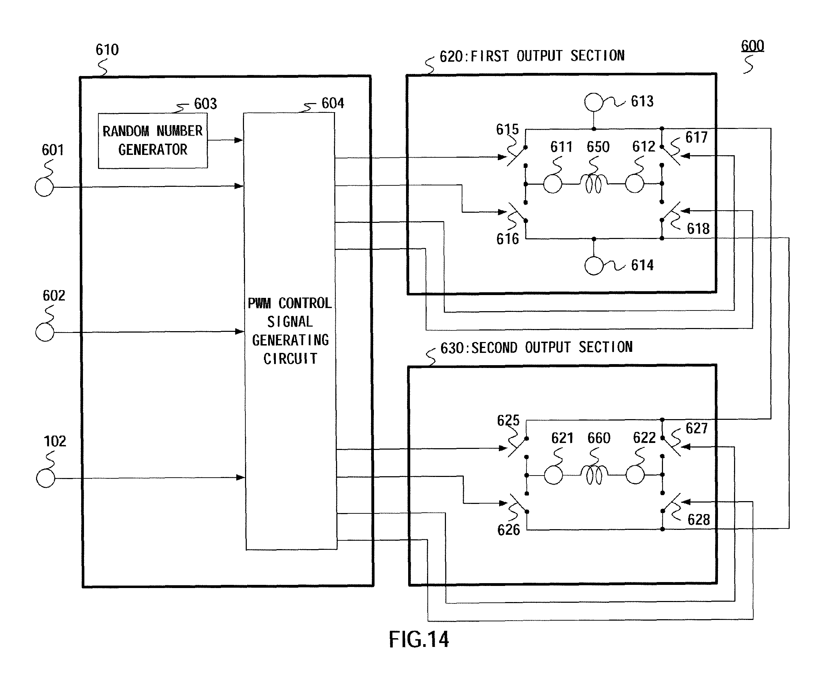

FIG.14 is a circuit diagram showing a configuration of the class D amplifier according to Embodiment 6 of the present invention. In the description of this embodiment, components that are the same as ones in FIG.3 are assigned the same reference numerals without further explanations.

In FIG.14, class D amplifier 600 is configured having: output control section 610 that is configured with first stereo signal input terminal 601, second stereo signal input terminal 602, mute signal input terminal 102, random number generator 603, and PWM control signal generating circuit 604; first output section 620 that is configured with first and second output terminals 611 and 612 to which inductive load 650 such as a speaker is connected, first power supply terminal 613 that supplies the first potential, second power supply terminal 614 that supplies the second potential, first switch 615 that connects first power supply terminal 613 and first output terminal 611, second switch 616 that connects first output terminal 611 and secondpower supply terminal 614, third switch 617 that connects first power supply terminal 113 and second output terminal 612, and fourth switch 618 that connects second output terminal 612 and second power supply terminal 614; and second output section 630 that is configured with third and fourth output terminals 621 and 622 to which inductive load 660 such as a speaker is connected, first power supply terminal 613 that supplies the first potential, second power supply terminal 614 that supplies the second potential, fifth switch 625 that connects first power supply terminal 613 and third output terminal 621, sixth switch 626 connecting third output terminal 621 and second power supply terminal 614, seventh switch 627 that connects first power supply terminal 613 and fourth output terminal 622, and eighth switch 628 that connects fourth output terminal 622 and second power supply terminal 614.

For example, first output section 620 is an R-channel signal output section, second output section 630 is an L-channel signal output section, and first and second output sections 620 and 630 are stereo signal output sections.

Output control section 610 supplies a plurality of control signals for changing the state of first output terminal 611, second output terminal 612, third output terminal 621 and fourth output terminal 622, and is provided with random number generator 603 that takes individual random numbers that do not depend on the input value as output values, and PWM control signal generating circuit 604 that generates a final PWM control signal from the input value and output values of random number generator 603. Random number generator 603 is configured with a modulo pseudo-random generator configured with a small number of flip-flops and XOR circuits. Further, PWM control signal generating circuit 604 is configured using the circuit of FIG.4 or FIG.8.

First and second output sections 620 and 630 typically have a circuit configuration referred to as an H (full) bridge.
The most well-known function that is an advantage of an H (full) bridge output section is that it is possible to suppress characteristic power supply noise referred to as regenerative current even when inductive load 650 is connected between first output terminal 611 and second output terminal 612, and inductive load 660 is connected between third output terminal 621 and fourth output terminal 622.

Specifically, it is possible to use the MOS transistors described in Embodiments 2 to 4 as the eight switches 615 to 618 and 625 to 628 of class D amplifier 600. Further, the load such as a speaker connected between first output terminal 611 and second output terminal 612, and between third output terminal 621 and fourth output terminal 622, may include a capacitive load as shown in FIG.7, in addition to inductive loads 650 and 660.

The operation of class D amplifier 600 with the above-described configuration will be described. The basic operation is the same as in Embodiment 1.

In FIG.14, like a stereo equipment, a plurality of speech signals are supplied to PWM control signal generating circuit 604 via first stereo signal input terminal 601 and second stereo signal input terminal 602 as input signals. Individual random numbers are then supplied to PWM control signal generating circuit 604 from random number generator 603.

At this time, output of random values from random number generator 603 may be outputted by outputting all input signals once, or may be outputted two times in one pulse segment by carrying out time division multiplexing operation.

PWM control signal generating circuit 604 has eight one-bit signal lines, and is capable of individually controlling first switch 615, second switch 616, third switch 617, and fourth switch 618 configuring first stereo signal output section 620, and fifth switch 625, sixth switch 626, seventh switch 627 and eighth switch 628 configuring second stereo signal output section 630.

Further, first to eighth switches 615 to 618, and 625 to 628 are connected between the first potential supplied to first power supply terminal 613 and the second potential supplied to second power supply terminal 614.

When first potential VDD is supplied to first power supply terminal 613 and second potential VSS is supplied to second power supply terminal 614, as output states of first output terminal 611 and second output terminal 612 of first output section 620, second PWM control signal generating circuit 604 is capable of maintaining the first state where first output terminal 611 and second output terminal 612 are both at VDD, a second state where first output terminal 611 and second output terminal 612 are both at VSS, a third state where first output terminal 611 is at VDD and second output terminal 612 is at VSS, and a fourth state where first output terminal 611 is at VSS and second output terminal 612 is at VDD. When a mute signal is inputted to mute signal input terminal 102, PWM control signal generating circuit 604 maintains a fifth state where first output terminal 611 and second output terminal 612 are both high impedance by carrying out control so that first to fourth switches 615 to 618 of first output section 620 are turned off.

Similarly, PWM control signal generating circuit 604 is capable of maintaining a first state where third output terminal 621 and fourth output terminal 622 are both VDD, a second state where third output terminal 621 and fourth output terminal 622 are both VSS, a third state where third output terminal 621 is VDD and fourth output terminal 622 is VSS, and a fourth state where third output terminal 621 is VSS and fourth output terminal 622 is VDD, as each of the output states for third output terminal 621 and fourth output terminal 622 of second output section 630. When a mute signal is inputted to mute signal input terminal 102, PWM control signal generating circuit 604 maintains a fifth state where third output terminal 621 and fourth output terminal 622 are both high impedance by carrying out control so that fifth to eighth switches 625 to 628 of second output section 630 are turned off.

The predetermined time interval--the sampling frequency--is set at 200 kHz in this embodiment as in Embodiment 1, and the PWM clock frequency indicating the resolution of the PWM signal is set at 2 MHz as in Embodiment 1. Further, for the pulse shape of the PWM signal, the center of the predetermined time interval is set as a signal reference point as in Embodiment 1, so as to be always included in the Hi pulse section of the pulse signal.

In this embodiment, a plurality of (two) speech signals are also inputted as input signals via first stereo signal input terminal 601 and second stereo input terminal 602, and random number generator 603 and PWM control signal generator 604 carry out random number generation and PWM control signal generation for two channels. The operation is the same as Embodiment 1 except that the operation is carried out using the same method as Embodiment 1 for each channel. Further, the same methods as for Embodiments 2 to 5 can of course also be applied.

Therefore, according to Embodiment 6, it is possible to obtain the same advantages as Embodiment 1 for stereo signal input of such as a stereo equipment.

### (Embodiment 7)

Embodiment 6 has a structure where the number of input terminals and output sections for each of the embodiments is increased by one. In the case of speech output using a stereo or multiple channels, it is often the case that a plurality of input terminals and output sections are provided. However, setting the same number of PWM control signal generating circuits 604 as input terminals and output sections invites increases in the circuit scale and current consumption. Reduction of circuit scale by time division multiplexing and reduction of current consumption are therefore achieved. The following is a description of an example of applying time division multiplexing using Embodiment 7.

Out of Embodiments 1 to 6, the simplest method for achieving time division multiplexing is the case of a configuration with an address generating circuit, a ROM circuit and a pulse generating circuit.

Here, the case is considered where PWM control signal generating circuit 604 of FIG.14 is configured with address generating circuit 212, ROM circuit 213 and pulse generating circuit 214 shown in FIG.8 and FIG.9.

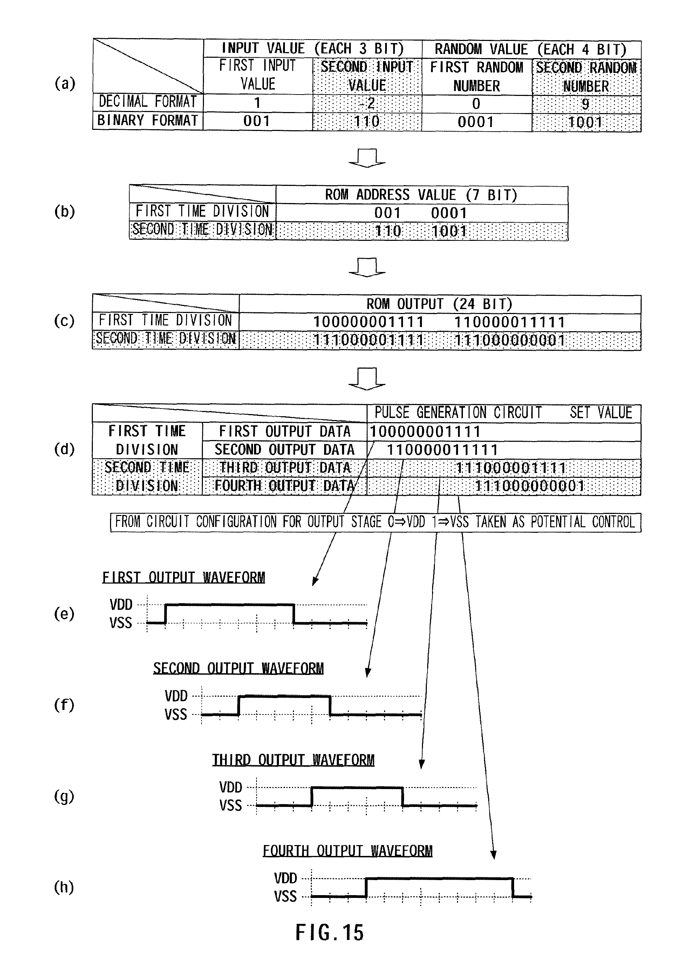

FIG.15 shows address/output values of the ROM of FIG.8 and output waveforms generated using these addresses/output values, and shows a specific example of waveforms corresponding to values of each signal for the case of carrying out time dividing operation. Referring to the specific example of FIG.6, it is assumed that the values and waveforms are the same as examples where the input value of first stereo signal input terminal 601 is 1 and second stereo signal input terminal 602 is -2, and output of random number generator 603 is 12 bits (refer to FIG.15(a)).

The operation of each section upon the time division operation will be described below.

As shown in FIGs. 15 (b) to (d), the input signal of a total of 18 bits inputted to the address generating circuit is first divided into a first ROM address value of 9 bits for controlling output of first stereo signal input terminal 601 and second ROM address value of 9 bits for controlling output of second stereo signal input terminal 602.

At the first time division, a first ROM output of twenty bits is immediately obtained from ROM circuit 213 (refer to FIG.8) using the first ROM address value of 9 bits for controlling output of first stereo signal input terminal 601. The higher-order ten bits of the first ROM output of the first time division are then inputted as an output control signal for first output terminal 611, and the lower-order ten bits are inputted as an output control signal for second output terminal 602 to pulse generating circuit 214 (refer to FIG.8).

At the second time division, a second ROM output of twenty bits is immediately obtained from ROM circuit 213 using the second ROM address value of nine bits for controlling output of second stereo signal input terminal 601. The higher-order ten bits of the second ROM output of the second time division are then inputted as an output control signal for third output terminal 621, and the lower-order ten bits are inputted as an output control signal for fourth output terminal 622 to pulse generating circuit 214.

It is only necessary to complete the above operation within the time for one wave of the PWM pulse, and it is possible to implement time division multiplexing simply and at an extremely high speed, particularly in the case of using a ROM.

A setting value for the pulse generation circuit set in this time division multiplexing operation is sequentially transmitted by a shift register in synchronization with the transmission timing of the PWM pulse, and the waveforms and differential output signals shown in FIG.6 can be obtained.

As described above, according to Embodiment 7, PWM control signal generating circuit 604 that supplies a PWM control signal to first output section 620 and second output section 630 of class D amplifier 600 shown in FIG. 14 is configured with address generating circuit 212, ROM circuit 213 and pulse generating circuit 214 shown in FIG.8, and these perform time division multiplexing operation, so that it is possible to obtain the same advantages as in Embodiments 1 to 6 in a multichannel scheme including a stereo signal. Further, since the output is the address specification/output value using ROM circuit 213 etc., it is possible to readily carry out time division multiplexing operation and realize reduction of the circuit scale and current consumption.

The above descriptions are examples of preferred embodiments of the present invention, and the present invention is by no means limited to this. For example, the above-described embodiments describe examples of application to various sound apparatuses, but it goes without saying that application is also similarly possible to equipment providing equipments that amplify sound.

Further, the name of class D amplifier is used in the above-described embodiments for ease of explanation, and power amplifier circuit, or class D switching amplifier etc. is also acceptable.

Moreover, the type, number, and connection method of each circuit section such as a flip-flop, configuring the class D amplifier, are by no means limited to the embodiments described above. Further, it is preferable to use an H (full) bridge circuit at the output section for reducing power supply noise, but this is by no means limited to an H (full) bridge, and any kind of output section is possible providing that potential difference between the first output terminal and second output terminal is outputted as a differential signal output. Further, differential output may also be described as conceptually including a so-called single output.

As described above, according to the present invention, by fixing a sampling frequency, adding a pulse signal with a random width uncorrelated with the input signal to a width of one of the PWM signal, and making the PWM signal of the inverted phase output a pulse signal with the same width as the above-described pulse signal with the randomwidth, it is possible to reduce a distortion for a specific sampling frequency, the frequency of half of this frequency, and frequencies that are multiples of this frequency to a level where the LPF is not required even when the input value is a fixed value or a signal that changes slightly, and implement a class D amplifier only using a simple and small-scale control circuit. As a result, it is possible to improve power efficiency and reduce costs.

Therefore, the class D amplifier according to the present invention is not only suitable for class D amplifiers for various sound apparatuses regardless of a single channel scheme or a multi-channel scheme, but can also be broadly applied to class D amplifiers in electronic equipments other than the sound apparatus.

The present invention is not limited to the above described embodiments, and various variations and modifications may be possible without departing from the scope of the present invention.

This application is based on the Japanese Patent Application No. 2005-359328 filedon June 19, 2005, entire content of which is expressly incorporated by reference herein.

## Claims

1. A class D amplifier comprising:
an output section (120) that takes a potential difference between a first output terminal (111) and a second output terminal (112) as a differential signal output; and
an output control section (110) that supplies a PWM control signal for changing the state of the potential difference between the first output terminal (111) and the second output terminal (112),
wherein the output control section (110) comprises a pulse signal generating section that divides a pulse signal outputted at a reference point between sampling frequencies into a plurality of pulse signals with random widths that do not include the reference point, and outputs the pulse signals with random widths.

2. The class D amplifier according to claim 1, wherein the pulse signal generating section divides the pulse signal at random positions and outputs the pulse signals.

3. The class D amplifier according to claim 1, wherein the pulse signal generating section generates a plurality of pulse signals uncorrelated with the input values in a random manner, and outputs a plurality of pulse signals in which a total value of pulse widths of a plurality of pulse signals remaining after subtracting another pulse signal from one generated pulse signal has a one-to-one relationship with the input values.

4. The class D amplifier according to claim 1, wherein the pulse signal generating section comprises:
a random number generating circuit (103) that outputs random values uncorrelated with the input values; and
a PWM control signal generating circuit (104) that generates a PWM control signal for controlling the output section from the input values and the output values of the random number generating circuit (103).

5. The class D amplifier according to claim 4, wherein the PWM control signal generating circuit (104) comprises:
a sign determination circuit (134) that determines signs and zero of the input values;
an absolute value generating circuit (135) that extracts an absolute value of a input signal;
a selection circuit (136,137) that selects and outputs one of the output value of the absolute value generating circuit (135) and zero based on the output results of the sign determination circuit (134);
an addition circuit (138) that adds the output values of the random number generating circuit (103) and the output value of the selection circuit (136,137); and
a signal generating circuit (104) that generates a final PWM control signal based on the output results of the sign determination circuit (134), the output value of the addition circuit (138) and the output values of the random number generating circuit (103), or makes the first output terminal and the second output terminal high impedance based on a mute signal.

6. The class D amplifier according to claim 4, wherein the PWM control signal generating circuit (104) comprises:
an address generating circuit (212) that generates an address signal from the input values and the output values of the random number generating circuit (103);
a ROM circuit (213) that outputs pulse waveform information based on the output value of the address generating circuit (212); and
a pulse generating circuit (214) that generates a final PWM control signal based on the output value of the ROM circuit (213), or makes the first output terminal (111) and the second output terminal (112) high impedance based on a mute signal.

7. The class D amplifier according to claim 1, wherein the output section (120) comprises five output states as a result of supply of a PWM control signal generated using the input values to the output control section (110), the five output states of:
a first output state where potentials of the first output terminal (111) and the second output terminal (112) are both first potential;
a second output state where the potentials of the first output terminal (111) and the second output terminal (112) are both second potential;
a third output state where the potential of the first output terminal (111) is the first potential, and the potential of the second output terminal (112) is the second potential;
a fourth output state where the potential of the first output terminal (111) is the second potential, and the potential of the second output terminal (112) is the first potential; and
a fifth output state where the states of the first output terminal (111) and the second output terminal (112) are both high impedance.

8. The class D amplifier according to claim 1, wherein:
the output section (120) comprises first, second, third and fourth switches (115,116,117,118);
the first and second switches (115,116) are connected in series between the first potential and the second potential;
the first output terminal (111) is provided at a connection point of the first and second switches (115, 116, 117, 118);
the third and fourth switches (117,118) are connected in series between the first potential and the second potential; and
the second output terminal (112) is provided at a connection point of the third and fourth switches (117,118).

9. The class D amplifier according to claim 1, wherein:
the output section (120) comprises first and second P-channel MOS transistors (221,223), and first and second N-channel MOS transistors (222,224);
sources of the first P-channel MOS transistor (221) and the second P-channel MOS transistor (223) are connected to the first potential;
sources of the first N-channel MOS transistor (222) and the second N-channel MOS transistor (224) are connected to the second potential;
the first output terminal (111) is provided at a connection point of each drain of the first P-channel MOS transistor (221) and the first N-channel MOS transistor (222); and
the second output terminal (112) is provided at a connection point of each drain of the second P-channel MOS transistor (223) and the second N-channel MOS transistor (224).

10. The class D amplifier according to claim 9, wherein the output section (120) further comprises:
a third P-channel MOS transistor (331) where a drain is connected to the first output terminal (111), an inverted signal of a signal applied to the first P-channel MOS transistor (221) is applied to a gate, a source is in a floating state, and a channel width is the same size as for the first P-channel MOS transistor (221);
a third N-channel MOS transistor (332) where a drain is connected to the first output terminal (111), an inverted signal of a signal applied to the first N-channel MOS transistor (222) is applied to a gate, a source is in a floating state, and a channel width is the same size as for the first N-channel MOS transistor (222);
a fourth P-channel MOS transistor (333) where a drain is connected to the second output terminal (112), an inverted signal of a signal applied to the second P-channel MOS transistor (223) is applied to a gate, a source is in a floating state, and a channel width is the same size as for the second P-channel MOS transistor (223); and
a fourth N-channel MOS transistor (334) where a drain is connected to the second output terminal (112), an inverted signal of a signal applied to the secondN-channel MOS transistor (224) is applied to a gate, a source is in a floating state, and a channel width is the same size as for the second N-channel MOS transistor (224).

11. The class D amplifier according to claim 9, wherein the output section (120) further comprises:
a third P-channel MOS transistor (431) where a source and drain are connected to the first output terminal (111), an inverted signal of a signal applied to the first P-channel MOS transistor (221) is applied to a gate, and a channel width is half the size of the channel width of the first P-channel MOS transistor (221);
a thirdN-channelMOS transistor (432) where a source and drain are connected to the first output terminal (111) an inverted signal of a signal applied to the first N-channel MOS transistor (222) is applied to a gate, and a channel width is half the size of the channel width of the first N-channel MOS transistor (222);
a fourth P-channel MOS transistor (433) where a source and drain are connected to the second output terminal (112), an inverted signal of a signal applied to the second P-channel MOS transistor (223) is applied to a gate, and a channel width is half the size of the channel width of the second P-channel MOS transistor (223); and
a fourth N-channel MOS transistor (434) where a source and drain are connected to the second output terminal (112), an inverted signal of a signal applied to the second N-channel MOS transistor (224) is applied to a gate, and a channel width is half the size of the channel width of the second N-channel MOS transistor (224).

12. The class D amplifier according to claim 9, wherein the output section (120) further comprises:
a fifth P-channel MOS transistor (521) where a source is connected to the drain of the first P-channel MOS transistor (221), a gate is connected to the drain of the first N-channel MOS transistor (222), and a drain is connected to the first output terminal (111);
a fifthN-channelMOS transistor (522) where a source is connected to the drain of the first N-channel MOS transistor (222), a gate is connected to the drain of the first N-channel MOS transistor (222), and a drain is connected to the first output terminal (111);
a sixth P-channelMOS transistor (523) where a source is connected to the drain of the second P-channel MOS transistor (223), a gate is connected to the drain of the second N-channel MOS transistor (224), and a drain is connected to the second output terminal (112); and
a sixth N-channel MOS transistor (524) where a source is connected to the drain of the second N-channel MOS transistor (224), a gate is connected to the drain of the second N-channel MOS transistor (224), and a drain is connected to the second output terminal (112).

13. The class D amplifier according to claim 1, wherein a load (150,151) for applying a current between the first output terminal (111) and the second output terminal (112) is connected.

14. The class D amplifier according to claim 1, wherein an inductive load (150) is connected between the first output terminal (111) and the second output terminal (112).

15. The class D amplifier according to claim 1, wherein a load including a capacitive load (151) is connected between the first output terminal (111) and the second output terminal (112).

16. The class D amplifier according to claim 1, wherein:
a plurality of the output sections (120) are provided; and
part or all of the output control section (110) performs time division multiplexing operation.
